(19) Europäisches Patentamt
European Patent Office
Office européen des brevets

(11) **EP 4 418 001 A1**

(12) **EUROPEAN PATENT APPLICATION**
published in accordance with Art. 153(4) EPC

(43) Date of publication:
**21.08.2024 Bulletin 2024/34**

(21) Application number: **22880646.9**

(22) Date of filing: **25.08.2022**

(51) International Patent Classification (IPC):
*G01S 7/481* [(2006.01)]     *G02B 6/12* [(2006.01)]
*H01L 27/15* [(2006.01)]

(52) Cooperative Patent Classification (CPC):
**G01S 7/481; G02B 6/12; H01L 27/15**

(86) International application number:
**PCT/JP2022/032010**

(87) International publication number:
**WO 2023/062949 (20.04.2023 Gazette 2023/16)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.10.2021 JP 2021168286**

(71) Applicant: **Sony Semiconductor Solutions
Corporation
Atsugi-shi, Kanagawa 243-0014 (JP)**

(72) Inventors:
• YASU Yohtaro
Atsugi-shi, Kanagawa 243-0014 (JP)
• EBIKO Yoshiki
Atsugi-shi, Kanagawa 243-0014 (JP)
• TERADA Haruhiko
Atsugi-shi, Kanagawa 243-0014 (JP)
• KOBAYASHI Takashi
Atsugi-shi, Kanagawa 243-0014 (JP)

(74) Representative: **MFG Patentanwälte
Meyer-Wildhagen Meggle-Freund
Gerhard PartG mbB
Amalienstraße 62
80799 München (DE)**

(54) **RANGEFINDER**

(57)     Provided is a ranging device capable of suppressing an electric power loss and a decrease in an SNR at low cost.

A ranging device of the present disclosure includes a photonic circuit and an electric circuit on the same semiconductor chip, the photonic circuit including: a light source; a waveguide that guides light from the light source; an optical switch distribution network that distributes first light split from the light; a grating array that outputs the first light distributed by the optical switch distribution network to an external target and receives the first light reflected from the target as reflected light; a first coupler that combines the reflected light with second light split from the light; and a first photodiode that photoelectrically converts light combined by the first coupler into a first electric signal, and the electric circuit including: a power supply that supplies electric power to the light source and the optical switch distribution network; and a controller that controls the power supply.

FIG. 1

**Description**

TECHNICAL FIELD

The present disclosure relates to a ranging device.

BACKGROUND ART

With the advancement of photonics manufacturing technology, photonics optical arrays are applied to many applications such as light detection and ranging, free space communication, holographic displays, and the like.

CITATION LIST

PATENT DOCUMENT

Patent Document 1: U.S. Patent Publication No. 2021/0109195
Patent Document 2: U.S. Patent Publication No. 2021/0018598
Patent Document 3: U.S. Patent Publication No. 2017/0184450
Patent Document 4: U.S. Patent Publication No. 2018/0267250

SUMMARY OF THE INVENTION

PROBLEMS TO BE SOLVED BY THE INVENTION

However, if a photonics integrated circuit and an electronics circuit are formed on separate chips and these chips are assembled, an insertion loss of laser light occurs in the entire system. The insertion loss of the laser light leads to an electric power loss and a decrease of a signal-to-noise rate (SNR).

In a case where a laser oscillator serving as a light source is mounted on a semiconductor substrate, misalignment of the laser oscillator with respect to the semiconductor substrate leads to the insertion loss of the laser light. Furthermore, manufacturing cost is increased in order to accurately position the laser oscillator with respect to the semiconductor substrate. Moreover, a decrease in distance measurement effectiveness due to coherence (phase noise) of the laser light becomes a problem.

Therefore, the present disclosure aims to provide a ranging device capable of suppressing an electric power loss and a decrease of an SNR at low cost.

SOLUTIONS TO PROBLEMS

A ranging device according to one aspect of the present disclosure includes a photonic circuit and an electric circuit on the same semiconductor chip, the photonic circuit including: a light source; a waveguide that guides light from the light source; an optical switch distribution network that distributes first light split from the light; a grating array that outputs the first light distributed by the optical switch distribution network to an external target and receives the first light reflected from the target as reflected light; a first coupler that combines the reflected light with second light split from the light; and a first photodiode that photoelectrically converts light combined by the first coupler into a first electric signal, and the electric circuit including: a power supply that supplies electric power to the light source and the optical switch distribution network; and a controller that controls the power supply.

The electric circuit further includes: a heater that heats the grating array; and a power supply control section that controls supply of electric power to the heater.

The heater is provided to correspond to each of a plurality of waveguides provided in the grating array.

The photonic circuit further includes a modulator that modulates the light from the light source, and the electric circuit further includes a high frequency generating circuit that supplies a high-frequency signal to the modulator.

The photonic circuit further includes a splitter that splits the light into the first light and the second light, and a circulator that sends the first light to the optical switch distribution network and sends the second light to the first coupler.

The photonic circuit further includes a second coupler that splits the light into the first light and the second light, sends the first light to the optical switch distribution network, and sends the second light to the first coupler.

The photonic circuit further includes: a splitter that splits the light into the first light and the second light; and a second coupler that splits the first light into third light and fourth light, sends the third light to the optical switch distribution network, and terminates the fourth light.

The photonic circuit further includes a light amplifier that is provided in the waveguide and amplifies the light or the first light.

A feedback circuit that detects a change in a phase of the light and performs feedback control of the light from the light source is further provided.

The feedback circuit includes: a delay circuit that generates delay light obtained by delaying a part of the light from the light source; a third coupler that combines another part of the light from the light source and the delay light; a second photodiode that photoelectrically converts light combined by the third coupler into a second electric signal; a comparison circuit that compares the second electric signal with a reference signal indicating a delay amount of the delay light and outputs a comparison result; and an integrator circuit that integrates the comparison result and controls the power supply of the light source.

The photonic circuit further includes: a second splitter that splits the second light; a third splitter that splits the reflected light; the third coupler that combines a part of the second light split by the second splitter and a part of the reflected light split by the third splitter and subjected to phase modulation; and a second photodiode that photoelectrically converts light combined by the third coupler into a second electric signal, and a signal processing circuit that executes distance measurement processing using the first electric signal and the second electric signal is further provided.

The grating array is separated into a transmission array that transmits the first light and a reception array that receives the reflected light.

The photonic circuit is provided on a first semiconductor substrate, the electronics circuit is provided on a second semiconductor substrate, and the first and second semiconductor substrates are laminated on each other and electrically connected.

The photonic circuit is provided on a first semiconductor substrate, an analog circuit of the electronics circuit is provided on a second semiconductor substrate, a digital circuit of the electronics circuit is provided on a third semiconductor substrate, and at least the first and second semiconductor substrates are laminated on each other and electrically connected.

The first semiconductor substrate is larger than the second semiconductor substrate, and the second semiconductor substrate is laminated on a region other than the grating array in the first semiconductor substrate.

The light source includes a plurality of first laser generators and a second laser generator that generates light in place of any first laser generator out of the plurality of first laser generators.

A prism provided above the grating array, a photodiode that detects a part of the first light reflected from the prism, and an AD converter that converts an electric signal from the photodiode into a digital value are further provided.

A prism provided above the grating array, a test grating array that irradiates the prism with test light, a photodiode that detects the test light reflected from the prism, and an AD converter that converts an electric signal from the photodiode into a digital value are further provided.

A photodiode that detects a part of the light from the light source, and an AD converter that converts an electric signal from the photodiode into a digital value are further provided.

An AD converter that converts the comparison result into a digital value is further provided.

A thermometer that senses a temperature of any location of the photonic circuit or the electronics circuit and outputs the temperature as a digital value is further provided.

The controller compares the digital value with a threshold to determine an abnormality.

BRIEF DESCRIPTION OF DRAWINGS

Fig. 1 is a block diagram illustrating a configuration example of a ranging device according to a first embodiment.
Fig. 2 is a view illustrating a configuration example of a waveguide of laser light.
Fig. 3 is a view illustrating a configuration example of the waveguide of laser light.
Fig. 4 is a view illustrating a configuration example of the waveguide of laser light.
Fig. 5A is a plan view illustrating an example of a grating structure of a grating array.
Fig. 5B is a cross-sectional view illustrating an example of the grating structure of the grating array.
Fig. 6A is a plan view illustrating an example of the grating structure of the grating array.
Fig. 6B is a cross-sectional view illustrating an example of the grating structure of the grating array.
Fig. 7A is a plan view illustrating an example of the grating structure of the grating array.
Fig. 7B is a cross-sectional view illustrating an example of the grating structure of the grating array.
Fig. 8 is a cross-sectional view of the grating array in a direction perpendicular to a Y direction.
Fig. 9 is a cross-sectional view of the grating array in a direction perpendicular to an X direction.
Fig. 10 is a conceptual diagram illustrating a state in which the grating array emits first light.

Fig. 11 is a cross-sectional view illustrating another modification example of the grating array.

Fig. 12 is a cross-sectional view illustrating another modification example of the grating array.

Fig. 13 is a plan view illustrating an example of a planar layout of the grating array.

Fig. 14 is a plan view illustrating an example of the planar layout of the grating array.

Fig. 15 is a plan view illustrating an example of the planar layout of the grating array.

Fig. 16A is a cross-sectional view illustrating a configuration example of an attenuator 80.

Fig. 16B is a plan view illustrating a configuration example of the attenuator 80.

Fig. 17A is a cross-sectional view illustrating a configuration example of the attenuator 80.

Fig. 17B is a plan view illustrating a configuration example of the attenuator 80.

Fig. 18A is a cross-sectional view illustrating a configuration example of the attenuator 80.

Fig. 18B is a plan view illustrating a configuration example of the attenuator 80.

Fig. 19 is a block diagram illustrating a configuration example of a ranging device according to a second embodiment.

Fig. 20 is a block diagram illustrating a configuration example of a ranging device according to a third embodiment.

Fig. 21 is a cross-sectional view illustrating a configuration example of a heater.

Fig. 22 is a cross-sectional view illustrating the configuration example of the heater.

Fig. 23 is a cross-sectional view illustrating a configuration example of the heater.

Fig. 24 is a cross-sectional view illustrating the configuration example of the heater.

Fig. 25 is a cross-sectional view illustrating a configuration example of the heater.

Fig. 26 is a cross-sectional view illustrating the configuration example of the heater.

Fig. 27 is a view illustrating an example in which the heater of Fig. 21 is combined with the heater of Fig. 25.

Fig. 28 is a view illustrating an example in which the heater of Fig. 21 is combined with the heater of Fig. 26.

Fig. 29 is a block diagram illustrating a configuration example of a ranging device according to a fourth embodiment.

Fig. 30 is a diagram illustrating a configuration example of a modulator.

Fig. 31 is a cross-sectional view illustrating a configuration example of a region of the modulator to which a high-frequency signal is applied.

Fig. 32 is a block diagram illustrating a configuration example of a ranging device according to a fifth embodiment.

Fig. 33 is a block diagram illustrating a configuration example of a ranging device according to a sixth embodiment.

Fig. 34 is a block diagram illustrating a configuration example of a ranging device according to a seventh embodiment.

Fig. 35 is a block diagram illustrating a configuration example of a ranging device according to an eighth embodiment.

Fig. 36 is a block diagram illustrating a configuration example of a ranging device according to a ninth embodiment.

Fig. 37 is a block diagram illustrating a configuration example of a ranging device according to a tenth embodiment.

Fig. 38 is a block diagram illustrating a configuration example of a ranging device according to an eleventh embodiment.

Fig. 39 is a conceptual diagram illustrating a laminated state of first and second semiconductor substrates.

Fig. 40 is a block diagram illustrating a configuration example of a ranging device according to a twelfth embodiment.

Fig. 41 is a conceptual diagram illustrating a laminated state of first and second semiconductor substrates of the twelfth embodiment.

Fig. 42 is a block diagram illustrating a configuration example of a ranging device according to a thirteenth embodiment.

Fig. 43 is a block diagram illustrating a configuration example of the second semiconductor substrate of the eleventh embodiment.

Fig. 44 is a block diagram illustrating a configuration example of the second semiconductor substrate and a third semiconductor substrate of the twelfth embodiment.

Fig. 45 is a cross-sectional view illustrating a configuration example of an optical amplifier.

Fig. 46 is a cross-sectional view illustrating another configuration example of the optical amplifier.

Fig. 47 is a diagram illustrating a configuration example of a laser light source.

Fig. 48 is a diagram illustrating a configuration example of the laser light source.

Fig. 49 is a conceptual diagram illustrating a function of sensing peeling of a prism.

Fig. 50 is a conceptual diagram illustrating the function of sensing peeling of the prism.

Fig. 51 is a conceptual diagram illustrating a function of sensing that an object adheres to the prism.

Fig. 52 is a block diagram illustrating a configuration of a ranging device having the function of peeling sensing or object adhesion sensing of the prism.

Fig. 53 is a block diagram illustrating a configuration example of a ranging device having a function of sensing an abnormality of power of laser light.

Fig. 54 is a block diagram illustrating a configuration example of a ranging device having a function of sensing an abnormality of a frequency or a phase of laser light.

Fig. 55 is a block diagram illustrating a configuration example of a ranging device having a function of sensing temperatures at a plurality of locations.

Fig. 56 is a flowchart illustrating a method for detecting various abnormalities.

Fig. 57 is a timing chart illustrating timings of failure sensing processing and abnormality sensing processing of the ranging device.

Fig. 58 is a timing chart illustrating timings of the failure sensing processing and the abnormality sensing processing of the ranging device.

Fig. 59 is a cross-sectional view illustrating an example of a laminated structure of the ranging device.

Fig. 60 is a cross-sectional view illustrating another example of the laminated structure of the ranging device.

Fig. 61 is a cross-sectional view illustrating still another example of the laminated structure of the ranging device.

Fig. 62 is a view illustrating a modification example of a method for mounting the laser light source.

Fig. 63 is a view illustrating the modification example of the method for mounting the laser light source.

Fig. 64 is a view illustrating the modification example of the method for mounting the laser light source.

Fig. 65 is a view illustrating another modification example of the method for mounting the laser light source.

Fig. 66 is a view illustrating another modification example of the method for mounting the laser light source.

Fig. 67 is a view illustrating another modification example of the method for mounting the laser light source.

Fig. 68 is a view illustrating another modification example of the method for mounting the laser light source.

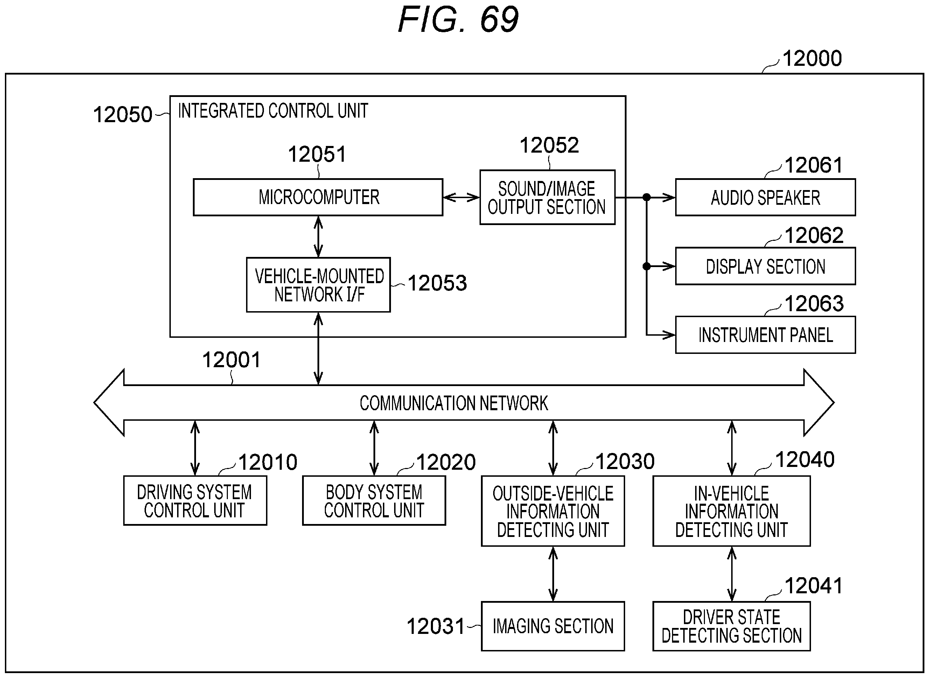

Fig. 69 is a block diagram illustrating an example of a schematic configuration of a vehicle control system.

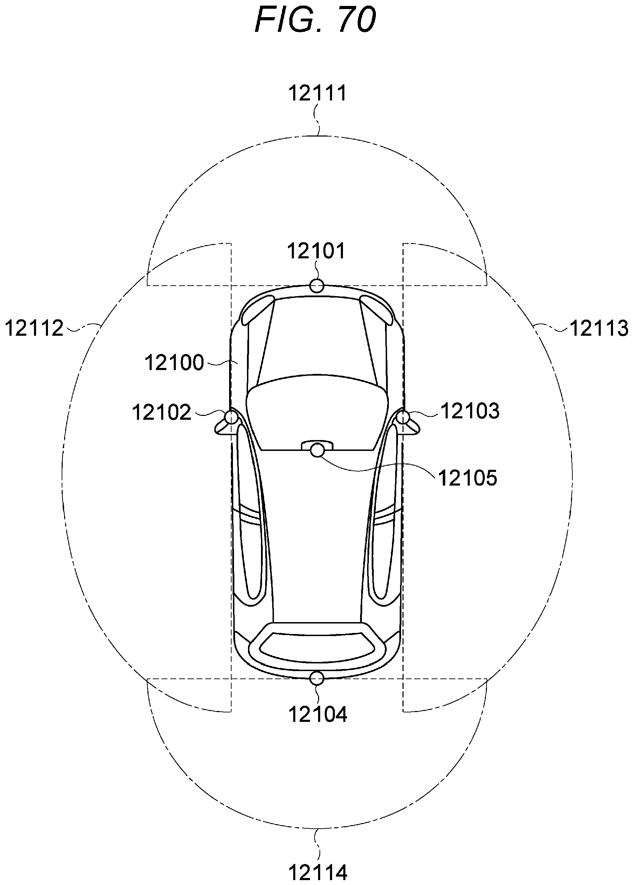

Fig. 70 is an explanatory diagram illustrating an example of installation positions of an outside-vehicle information detecting section and an imaging section.

MODE FOR CARRYING OUT THE INVENTION

Hereinafter, specific embodiments to which the present technology is applied will be described in detail with reference to the drawings. The drawings are schematic or conceptual, and the ratio of each part and the like are not necessarily the same as actual ones. In the specification and the drawings, similar elements as those described above concerning the previously described drawings are denoted by the same reference signs, and the detailed description thereof is appropriately omitted.

(First Embodiment)

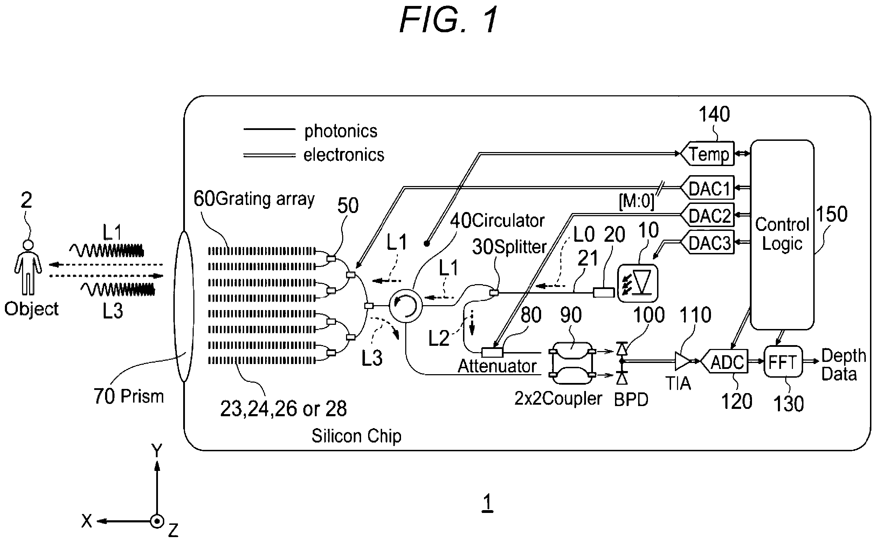

Fig. 1 is a block diagram illustrating a configuration example of a ranging device 1 according to a first embodiment. The ranging device 1 includes a laser light source 10, a coupler 20, a splitter 30, a circulator 40, an optical switch distribution network 50, a grating array 60, a prism 70, an attenuator 80, a 2 × 2 coupler 90, a balance photo diode (BPD) 100, a trans impedance amplifier (TIA) 110, an analogue-to-digital convertor (ADC) 120, a fast Fourier transform (FFT) calculation circuit 130, a thermometer 140, digital-to-analogue convertors (DAC) 1 to 4, and a logic control circuit 150 which are provided on one semiconductor chip. Note that the ADC 120 and the FFT 130 may be externally attached to the outside of the semiconductor chip. Note that the semiconductor chip in the claims may be configured on a single semiconductor substrate, or may be configured by laminating a plurality of semiconductor substrates.

The laser light source 10, the coupler 20, the splitter 30, the circulator 40, the optical switch distribution network 50, the grating array 60, the prism 70, the attenuator 80, the 2 × 2 coupler 90, and the BPD 100 are photonic circuits and are connected by waveguides that guide laser light. On the other hand, the TIA 110, the ADC 120, the FFT 130, the thermometer 140, the DACs 1 to 4, and the logic control circuit 150 are electronics circuits, and are connected by electrical wirings.

The present embodiment is a ranging device (LiDAR) of a frequency modulated continuation wave (FMCW) method in which such a photonic circuit and an electronics circuit are integrated on the same semiconductor substrate (for example, the same silicon substrate). The FMCW method is a distance measuring method of transmitting a frequency-modulated continuous wave and obtaining a distance from a frequency difference (beat frequency) between a transmission wave and a reflected wave.

The laser light source 10 receives supply of electric power from the DAC 3 or a dedicated power supply network, and oscillates laser light. The laser light source 10 can modulate a frequency of the laser light depending on the electric power from the DAC 3.

The coupler 20 inserts the laser light from the laser light source 10 into a waveguide 21. The laser light source 10, the coupler 20, and the waveguide 21 are formed on the same semiconductor substrate, and have a relatively low insertion loss of the laser light. The waveguide 21 guides laser light L0 to the splitter 30. The waveguide 21 is made of, for example, a silicon-based material (silicon, amorphous silicon, silicon nitride, or the like) formed on the semiconductor substrate.

The splitter 30 splits the laser light L0 into first light L1 and second light L2. A division ratio between the first light L1 and the second light L2 may be 1 : 1 or any other ratio. The first light L1 is guided to the circulator 40 via a waveguide. The second light L2 is guided to the attenuator 80 via another waveguide.

The circulator 40 transfers the first light L1 input from a first end to a second end on a side close to the optical switch distribution network 50 and the grating array 60.

The optical switch distribution network 50 switches to selectively pass the first light L1 to each of waveguides of the grating array 60. The optical switch distribution network 50 may substantially evenly distribute the first light L1 to the respective waveguides of the grating array 60.

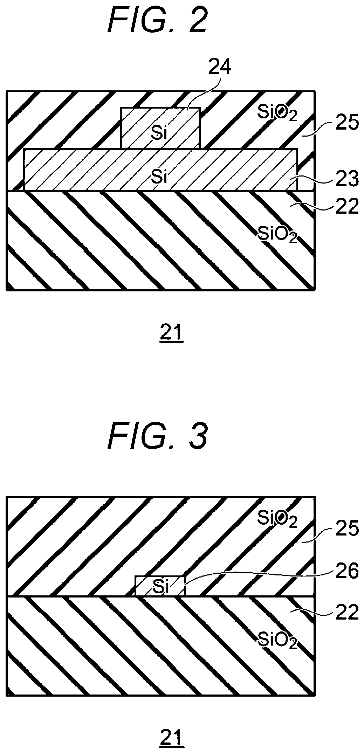

The grating array 60 two-dimensionally outputs the first light L1 distributed by the optical switch distribution network 50, and two-dimensionally receives the first light L1 reflected from a target 2 as reflected light L3. For example, the grating array 60 has a configuration in which a plurality of waveguides (23, 24, 26 or 28 in Figs. 2 to 4) extending in an X direction is arrayed in a Y direction. Each of the waveguides (23, 24, 26, or 28) has a grating extending in the Y direction. Therefore, the grating array 60 can emit the first light L1 in a Z direction two-dimensionally from an X-Y plane. A function of the grating array 60 will be described later.

The prism 70 refracts, diverges, or collects the first light L1 output from the grating array 60. Furthermore, the prism 70 collects the reflected light L3 from the target 2 on the grating array 60.

The reflected light L3 incident on the grating array 60 is collected on the circulator 40 via the optical switch distribution network 50 along a path opposite to that of the first light L1.

The circulator 40 receives the collected reflected light L3 from the second end and outputs the reflected light L3 from a third end on a side close to the coupler 90. In this manner, the circulator 40 is configured to emit the laser light L1 incident from the first end on a side close to the laser light source 10 to the second end and output the reflected light L3 incident from the second end to the third end.

The attenuator 80 attenuates the second light L2 to cause an amplitude of the second light L2 to be adapted to an amplitude of the reflected light L3. The first light L1 passes through an optical system from the laser light source 10 to the grating array 60, is emitted to the target 2, and is attenuated until being incident on the grating array 60 and reaching the coupler 90 as the reflected light L3. Therefore, the attenuator 80 attenuates the second light L2 in accordance with the attenuation from the first light L1 to the reflected light L3. Therefore, when the reflected light L3 is extremely great in a case where a subject is at a short distance or the like, it is possible to prevent a difference frequency signal combined by the following $2 \times 2$ coupler 90 from being saturated by the BPD 100 in the next stage to cause inconvenience.

The $2 \times 2$ coupler 90 receives the second light L2 from the attenuator 80 and the reflected light L3 from the circulator 40, combines the second light L2 and the reflected light L3, and outputs a composite wave.

The BPD 100 is a photodiode that receives an input of the composite wave combined by the coupler and photoelectrically converts the composite wave into an electric signal. The BPD 100 may input two composite waves combined by the coupler to two photodiodes. Furthermore, the BPD 100 may be a balanced photodiode in which photodiodes are connected in series, or may receive two composite waves combined by the coupler.

The TIA 110 amplifies the electrical signal. The TIA 110 may be configured to receive inputs of outputs from the two photodiodes as differential signals.

The ADC 120 performs AD conversion of the amplified electric signal into a digital signal.

The FFT 130 performs FFT processing on the digital signal from the ADC 120 to calculate a peak frequency of a difference frequency of the composite wave. The difference frequency of the composite wave depends on a distance from the ranging device 1 to the target 2. The distance from the ranging device 1 to the target 2 is proportional to the difference frequency between transmission light (the second light L2) and reception light (the reflected light L3). For example, in a case where the distance from the ranging device 1 to the target 2 is relatively short, the difference frequency decreases. In a case where the distance from the ranging device 1 to the target 2 is relatively long, the difference frequency increases. The peak frequency of the difference frequency is output from the FFT 130 to the outside of the ranging device 1 as depth data indicating the distance from the ranging device 1 to the target 2 and speed data indicating a speed.

The DAC 1 receives a digital control signal from the logic control circuit 150, and executes switching control of the optical switch distribution network 50 according to the digital control signal. The switching control of the optical switch distribution network 50 may cause the first light L1 to be substantially evenly distributed to the grating array 60 or cause the first light L1 to be guided to some waveguides of the grating array 60.

The DAC 2 receives a digital control signal from the logic control circuit 150 and controls an attenuation rate of the attenuator 80 according to the digital control signal. Therefore, the amplitude of the second light L2 can be adapted to that of the reflected light L3.

The DAC 3 receives a digital control signal from the logic control circuit 150, and controls an output of the laser light source 10 according to the digital control signal. Therefore, the laser light source 10 can modulate a wavelength of the laser light L0.

The thermometer 140 detects a temperature of the ranging device 1 under the control of the logic control circuit 150. A refractive index of the grating array 60 changes depending on a wavelength of the first light L1 and a temperature of a material forming a waveguide. When the refractive index of the grating array 60 changes, an emission direction of the first light L1 emitted from the grating array 60 changes according to the Bragg condition as described later. In the present embodiment, the temperature of the ranging device 1 may be made constant, and the emission direction of the first light L1 may be controlled by the wavelength of the first light L1 and the configuration of the grating array 60. Furthermore, the emission direction of the first light L1 may be controlled by the temperature of the ranging device 1, the wavelength of the first light L1, and the configuration of the grating array 60 as in a second embodiment.

The logic control circuit 150 controls the DACs 1 to 3, the ADC 120, the FFT 130, and the thermometer 140.

Figs. 2 to 4 are views illustrating configuration examples of the waveguides 21 of beams of the laser light L0 to L3. The waveguide 21 may be formed on a silicon on insulator (SOI) substrate.

Fig. 2 is a so-called rib waveguide. The waveguide 21 of Fig. 2 includes a first waveguide 23 provided on a BOX layer 22 of the SOI substrate and a second waveguide 24 provided on the first waveguide 23. The first and second waveguides 23 and 24 are formed by processing an SOI layer (for example, a silicon single crystal layer) of the SOI substrate. The first and second waveguides 23 and 24 are covered with an insulating film 25 such as a silicon oxide film, for example. The second waveguide 24 is thinner than the first waveguide 23, and is provided along and inside the first waveguide 23 when viewed from above a surface of the SOI substrate. The first and second waveguides 23 and 24 may be formed using, for example, amorphous silicon, a silicon nitride film, or the like in addition to the silicon single crystal.

The rib waveguide of Fig. 2 has a relatively large cross-sectional area, thereby enabling insertion of laser light from an edge with a low loss. For example, the laser light L0 from the laser light source 10 can be inserted into the waveguide 21 with a low loss.

Fig. 3 is a so-called thin wire waveguide. The waveguide 21 of Fig. 3 includes a thin wire waveguide 26 provided on the BOX layer 22 of the SOI substrate. The thin wire waveguide 26 is formed by processing an SOI layer (for example, a silicon single crystal layer) of the SOI substrate. The thin wire waveguide 26 is covered with the insulating film 25 such as a silicon oxide film, for example. The thin wire waveguide 26 may be formed using, for example, amorphous silicon, a silicon nitride film, or the like in addition to the silicon single crystal.

The thin wire waveguide of Fig. 3 has a relatively small cross-sectional area, but can be easily curved accordingly, which is advantageous for routing the waveguide in a narrow region.

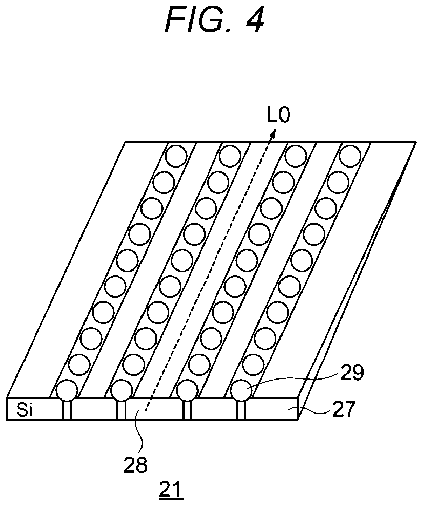

Fig. 4 is a view illustrating a configuration example of a waveguide (slow light wave guide (SLWG)) using a so-called photonic crystal. The waveguide of Fig. 4 may be formed on the BOX layer 22 of the SOI substrate. The photonic crystal forms a structure in which a refractive index periodically changes, and collects light into the waveguide. The structure in which the refractive index periodically changes is, for example, a large number of holes 29 on the order of nanometers. In Fig. 4, a large number of holes 29 are provided around the waveguide 28 in the SOI layer (for example, a silicon single crystal layer) 27. The hole 29 acts to confine the laser light L0 in the waveguide 28, and the laser light L0 travels along the waveguide 28 in a direction of an arrow.

The waveguide 28 using such a photonic crystal reduces the speed of the laser light L0 to a fraction of a high speed C0 in vacuum. Moreover, a refractive index of the photonic crystal greatly changes with temperature. For example, a refractive index of a silicon layer having no photonic crystal structure changes from 4 to 20 as the temperature increases to 2000 °C. On the other hand, a refractive index of silicon having a photonic crystal structure changes from 4 to 20 when heated to about 400 °C. When the photonic crystal structure is used in this manner, a refractive index of a substance (for example, silicon) can be greatly changed by a low temperature. That is, the photonic crystal structure can improve controllability by the temperature on the refractive index of the substance.

When the refractive index of the substance is N, a group refractive index by the photonic crystal is Ng, a wavelength of light in the substance is $\lambda$, a frequency of light in the substance is f, and the speed of light in vacuum is C0, an optical group velocity Cg in the substance can be expressed by Formula 1 from Formulas 2 and 3.

$$Cg = C/Ng \qquad (\text{Formula 1})$$

$$C = C0/N \qquad (\text{Formula 2})$$

$$Ng = N - \lambda \cdot (\Delta N/\Delta \lambda) \qquad (\text{Formula 3})$$

In Formula 1, when the group refractive index Ng is increased by using the photonic crystal structure, the optical group velocity Cg appears to be many times slower than the speed of light in the substance obtained by Formula 2 (slow light effect), and it is easy to efficiently control light by the action of heat or the wavelength. The second term of Formula 3 is small in a normal substance, but can be increased by using the photonic crystal structure. Therefore, the temperature of the substance or the wavelength $\lambda$ of light in the substance can be cause to effectively act by leverage on a change in the refractive index even if the amount of change thereof is not so large.

The waveguide 28 of the photonic crystal may be formed using, for example, amorphous silicon, a silicon nitride film, or the like in addition to the silicon single crystal.

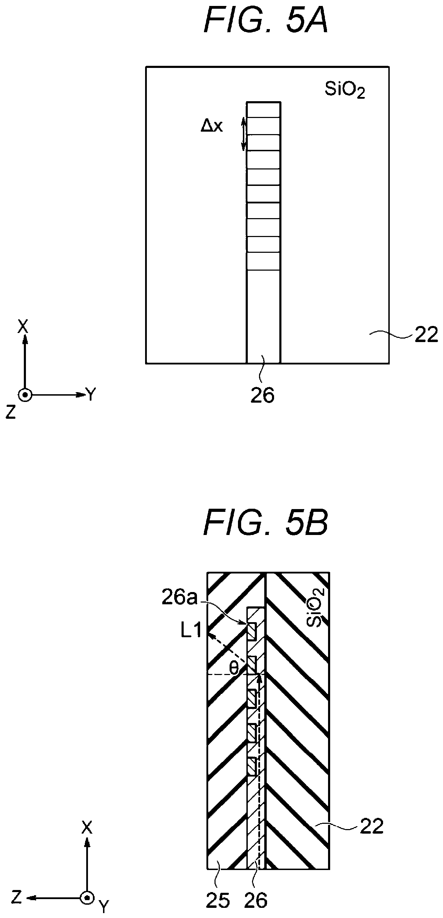

Figs. 5A, 6A, and 7A are plan views illustrating examples of grating structures of the grating array 60. Figs. 5B, 6B, and 7B are cross-sectional views illustrating examples of the grating structures of the grating array 60. Figs. 5A to 7B illustrate examples in which the grating structures are provided in the thin wire waveguide of Fig. 3. However, these grating structures may be applied to the rib waveguide or the photonic crystal.

In the grating structure illustrated in Figs. 5A and 5B, a recess 26a is provided on a surface of the waveguide 26. In this case, an uneven shape can be formed on the surface of the waveguide 26 by scraping (etching) the surface of the waveguide 26 to form the recess 26a.

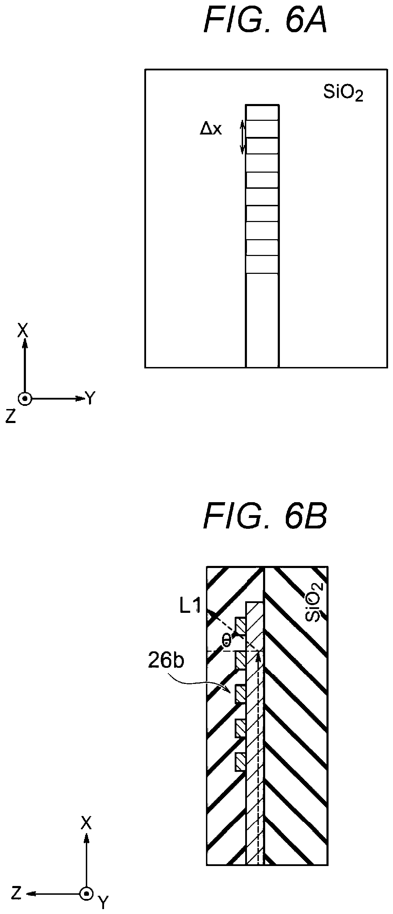

In the grating structure illustrated in Figs. 6A and 6B, a protrusion 26b is provided on the surface of the waveguide 26. In this case, it is sufficient to deposit a material of the protrusion 26b (for example, silicon nitride) on the surface of the waveguide 26, and process the material of the protrusion 26b using a lithography technique and an etching technique. Therefore, the uneven shape can be formed on the surface of the waveguide 26.

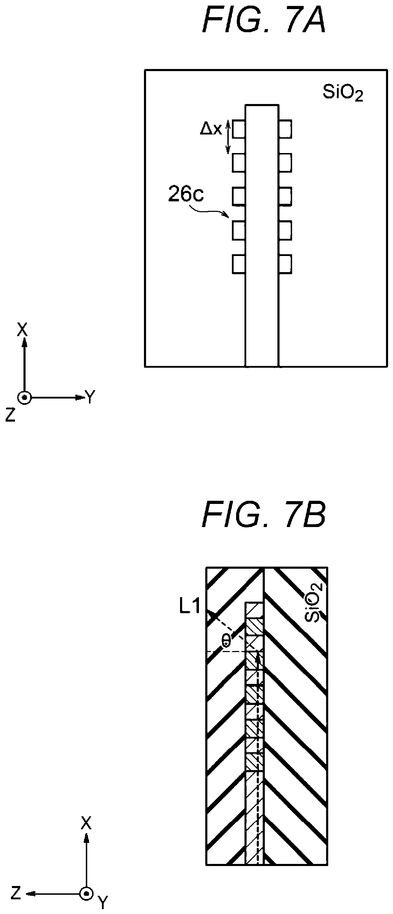

In the grating structure illustrated in Figs. 7A and 7B, a protrusion 26c is provided on a side surface of the waveguide 26. The protrusion 26c protrudes in the substantially horizontal direction from the side surface of the waveguide 26 on the upper surface of the BOX layer 22. In this case, when the SOI layer is processed using a lithography technique and an etching technique, the processing is only required to be performed so as to have the protrusion 26c on the side surface of the waveguide 26. Therefore, the protrusion 26c can be integrally formed on the side surface of the waveguide 26 to form the uneven shape.

When a period (pitch) of an uneven pattern of the grating structure is Δx, an emission angle of the first light L1 (an inclination angle from the Z direction substantially perpendicular to the surface of the BOX layer 22) is Θ, and an integer is m, the Bragg condition of Formula 4 is satisfied.

$$2 \times \Delta x \times \sin\theta = m \times \lambda \qquad \text{(Formula 4)}$$

It can be seen from Formulas 1 and 4 that the emission angle (deflection angle) θ of the first light L1 can be controlled by the refractive index N of the waveguide 26 and/or the wavelength λ of the first light L1 when the frequency f is constant.

In the present embodiment, the laser light source 10 can control the emission angle θ of the first light L1 emitted from the grating array 60 by changing the wavelength λ of the first light L1. Furthermore, the emission angle θ of the first light L1 may be controlled by changing the refractive index N of the grating array 60 at the temperature of the grating array 60 by a thermo-optic effect. The ranging device 1 may control the emission angle θ of the first light L1 using both the wavelength λ of the first light L1 and the refractive index N of the grating array 60.

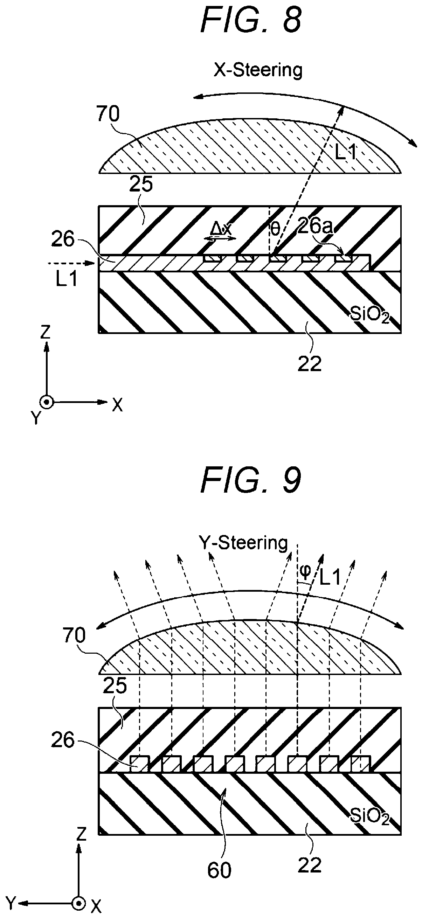

Fig. 8 is a cross-sectional view of the grating array 60 in a direction perpendicular to the Y direction. Fig. 9 is a cross-sectional view of the grating array 60 in a direction perpendicular to the X direction. Figs. 8 and 9 illustrate, as an example, the grating array 60 including the thin wire waveguide illustrated in Figs. 5A and 5B.

The grating array 60 includes the waveguide 26 extending in the X direction as illustrated in Fig. 8, and a plurality of the waveguides 26 is arrayed in the Y direction as illustrated in Fig. 9. Therefore, the grating array 60 refracts the first light L1, which has traveled in the X direction, to the Z direction and emits the first light L1 by the uneven grating structure provided in the X direction. The first light L1 emitted by the grating structure is emitted in the direction inclined in the X direction by the emission angle θ with respect to the Z direction. The emission angle θ can be controlled by the wavelength λ of the first light L1 or the refractive index N of the waveguide 26 as described above. That is, the grating array 60 can steplessly change the emission angle θ of the first light L1 diffracted in the X direction by changing the wavelength λ of the first light L1 or the refractive index N of the waveguide 26.

Furthermore, the plurality of waveguides 26 arrayed in the Y direction can emit the first light L1 in the grating array 60 as illustrated in Fig. 9. The waveguide 26 that emits the first light L1 is selected by switching of the optical switch distribution network 50. Therefore, any waveguide 26 among the plurality of waveguides 26 can emit the first light L1. The prism 70 is provided above the grating array 60 in the Z direction, and the prism 70 refracts the first light L1 emitted from the grating array 60 to irradiate the target 2. Therefore, the first light L1 is refracted by the prism 70 and can be inclined in the Y direction. That is, the grating array 60 can change the inclination angle φ of the first light L1 with respect to the Y direction in a stepwise manner by the waveguide 26 selected by the optical switch distribution network 50.

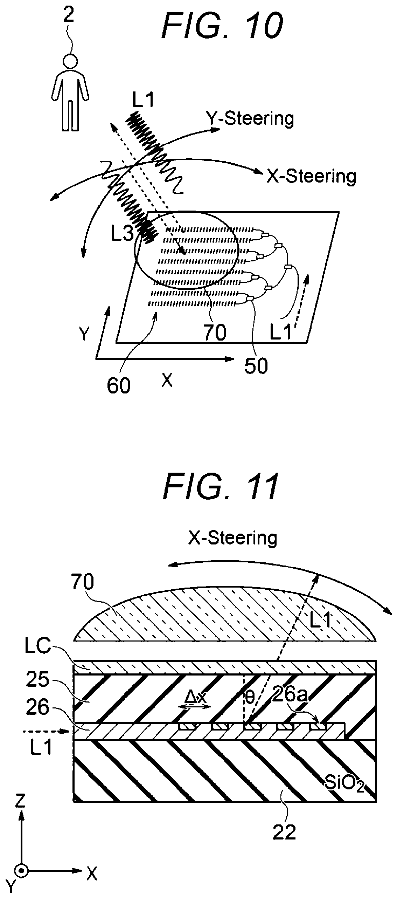

Fig. 10 is a conceptual diagram illustrating a state in which the grating array 60 emits the first light L1. The grating array 60 can change each of the deflection angle (Θ) of the first light L1 with respect to the X direction and the deflection angle (φ) of the first light L1 with respect to the Y direction. In this manner, the grating array 60 can two-dimensionally emit the first light L1 from the X-Y plane. That is, the grating array 60 can function as a two-dimensional scanner by changing the wavelength λ or the refractive index N of the first light L1 and switching the optical switch distribution network 50.

The combination of the two-dimensional scanner and the FMCW method can implement long distance measurement with low electric power. Furthermore, higher electric power efficiency and advanced distance measurement become possible by dynamically changing a distance measurement region, resolution, and illuminance power. Moreover, the ranging device 1 has a mono-static configuration, and light is transmitted and received through the single opening (the prism 70). Thus, only one optical system is required, which leads to low cost.

Furthermore, the reflected light L3 from the target 2 passes through a path opposite to the first light L1, is two-dimensionally received by the grating array 60 via the prism 70, passes through the waveguide 26, and enters the inside of the ranging device 1. Therefore, it is possible to perform distance measurement processing from the ranging device 1 to the target 2. Furthermore, since light is received via the prism 70 in the present embodiment, a size of a light receiving opening substantially increases, and an SNR can be improved.

Figs. 5A to 9 illustrate grating structures in a case where the thin wire waveguide 26 of Fig. 3 is applied to the grating array 60. These grating structures may be applied to the rib waveguides 23 and 24 of Fig. 2 or the photonic crystal of Fig. 4.

In a case where the grating structures are applied to the rib waveguides 23 and 24, the recess 26a, the protrusion 26b, and the protrusion 26c in Figs. 5A to 7B may be provided in any one or both of the waveguides 23 and 24.

In a case where the grating structures are applied to the photonic crystal structure, the recess 26a or the protrusion 26b may be provided along a row of the holes 29 substantially parallel to both sides of the waveguide 28. Alternatively, the recess 26a or the protrusion 26b may be provided along a row of the holes 29 in a direction substantially perpendicular to both the sides of the waveguide 28. In this case, openings of the holes 29 may appear on a bottom surface of the recess 26a or an upper surface of the protrusion 26b. Furthermore, in a case where the protrusion 26c is provided on both the sides of the waveguide 28, the protrusion 26c may protrude in a substantially vertical direction from both the sides of the waveguide 28 on a surface of the SOI layer 27, and the openings of the holes 29 may appear on an upper surface of the protrusion 26c.

The grating array 60 is made of, for example, an SOI layer (silicon single crystal), and can be formed using a material and a manufacturing method used in an existing complementary metal oxide semiconductor (CMOS) manufacturing step.

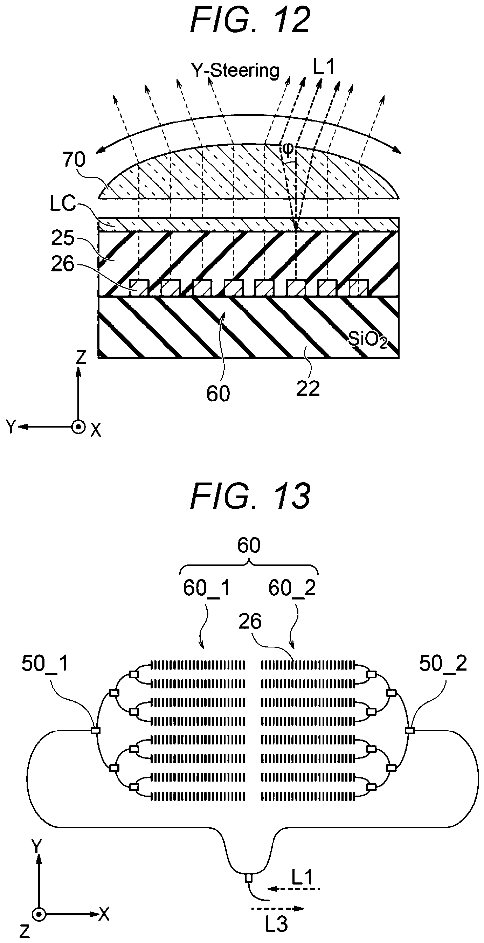

Figs. 11 and 12 are cross-sectional views illustrating another modification example of the grating array 60. Similarly to Fig. 8, Fig. 11 is a cross-sectional view of the grating array 60 in a direction perpendicular to the Y direction. Similarly to Fig. 9, Fig. 12 is a cross-sectional view of the grating array 60 in a direction perpendicular to the X direction.

This modification example is different from the grating array 60 of Figs. 8 and 9 in that a liquid crystal layer LC is provided above the grating array 60 in the Z direction (the emission direction of the first light L1).

The liquid crystal layer LC is provided on the insulating film 25 on the grating array 60, and can further widen the deflection angle of the first light L1. For example, in the liquid crystal layer LC, an irradiation width of the first light L1 in the X direction can be increased by further increasing the emission angle θ in the X direction. Furthermore, the grating array 60 can change the inclination angle φ with respect to the Y direction in a stepwise manner, but the inclination angle φ with respect to the Y direction is limited by an arrangement (pitch) of the waveguides 26 and the number of arrays. On the other hand, the liquid crystal layer LC can widen the deflection angle of the first light L1 with respect to the Y direction and widen the irradiation width of the first light L1 in the Y direction. The liquid crystal layer LC can also change the inclination angle φ of the first light L1 with respect to the Y direction steplessly. In this manner, the inclination angles φ of the first light L1 with respect to the X direction and the Y direction can be set more finely in the liquid crystal layer LC.

Figs. 13 to 15 are plan views illustrating examples of a planar layout of the grating array 60.

In the example of Fig. 13, the grating array 60 is configured to bisect the waveguide 26 in the longitudinal direction (extending direction, X direction). One grating array 60_1 is a grating array of a left half of the grating array 60, and an optical switch distribution network 50_1 is connected to the waveguide 26 thereof. The other grating array 60_2 is a grating array of a right half of the grating array 60, and an optical switch distribution network 50_2 is connected to the waveguide 26 thereof.

When the waveguide 26 is long, characteristics of light deteriorate during passage of the waveguide 26. On the other hand, deterioration of characteristics of the first light L1 in the waveguide 26 is suppressed by dividing the grating array 60 in the longitudinal direction and providing the optical switch distribution network 50 on both sides thereof as illustrated in Fig. 13.

Furthermore, the grating arrays 60_1 and 60_2 transmit the first light L1 and receive the reflected light L3, and thus, can perform distance measurement processing in parallel. Therefore, the ranging device 1 can perform highly accurate distance measurement processing.

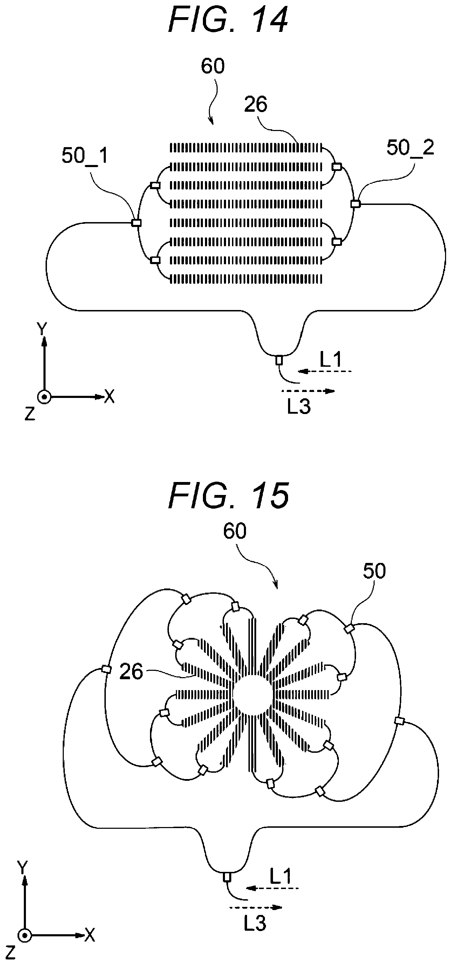

In the example of Fig. 14, the optical switch distribution networks 50 1 and 50_2 are alternately connected to the waveguides 26 adjacent in the Y direction in the grating array 60. For example, the optical switch distribution network 50_1 is connected to an odd-numbered waveguide among the plurality of waveguides 26, and the optical switch distribution network 50_2 is connected to an even-numbered waveguide among the plurality of waveguides 26.

Therefore, the optical switch distribution networks 50_1 and 50_2 are divided and arranged on both sides of the grating array 60, each configuration is relatively simple. Furthermore, routing of the optical switch distribution networks 50 1 and 50 2 are also facilitated. Thus, layout design of the grating array 60 and the optical switch distribution network 50 is facilitated.

Furthermore, since the first light L1 enters the grating array 60 substantially evenly from both the sides, the first light L1 emitted from the grating array 60 is also substantially even left and right.

In the example of Fig. 15, the waveguides 26 are arranged radially. The waveguides 26 extend in the radial direction from the center of the grating array 60. Therefore, the grating array 60 can change the emission angle θ of the first light L1 steplessly and substantially evenly in the radial direction from the center thereof. Therefore, the grating array 60 can efficiently collect the reflected light L3 from the target 2 at the center and the normal direction of the center, and can accurately measure the distance to the target 2.

The ranging device 1 according to the present embodiment is a solid-state ranging device using the FMCW method and a semiconductor element capable of two-dimensional scanning of the X-Y plane. Thus, since the ranging device 1 has a low insertion loss of light and a high SNR, it is possible to realize long distance measurement with low electric power. Furthermore, the ranging device 1 can dynamically change the distance measurement region, resolution, and illuminance power of light. Therefore, the electric power efficiency can be further improved, and the advanced distance measurement processing can be performed. Furthermore, in the present embodiment, the grating array 60 and the prism 70 serve both transmission and reception, and the transmission and reception can be performed with a single opening portion. Therefore, the cost can be reduced with only one optical system.

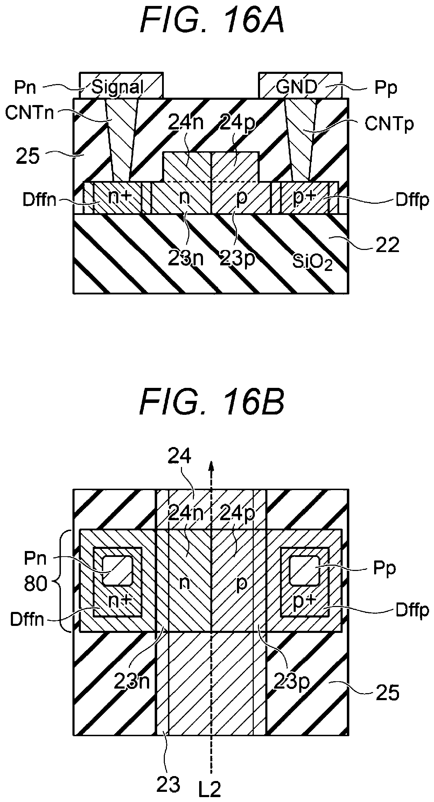

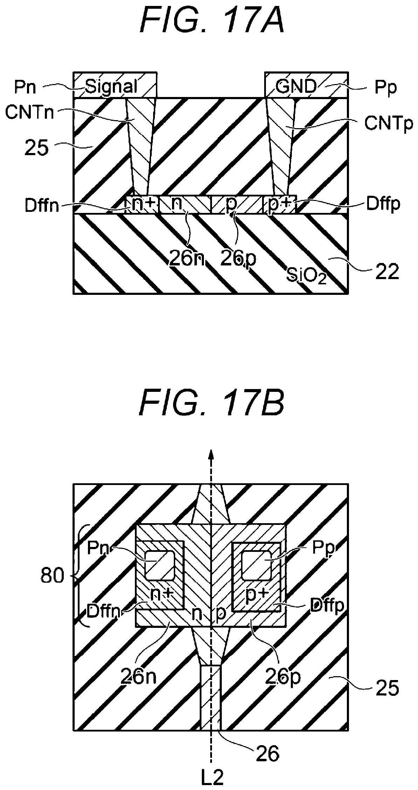

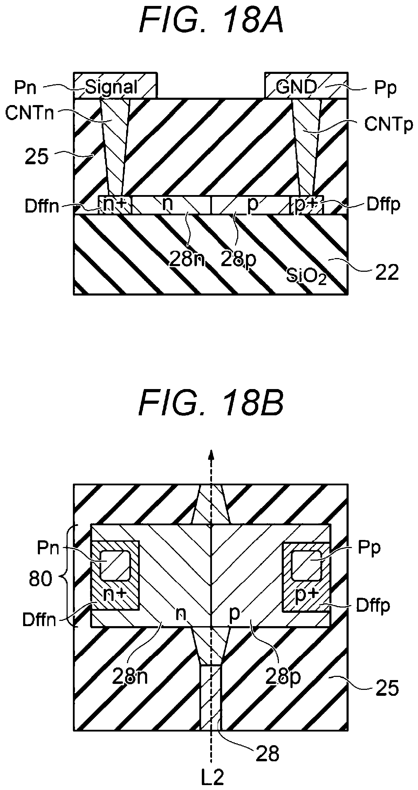

Figs. 16A, 17A, and 18A are cross-sectional views illustrating configuration examples of the attenuator 80. Figs. 16B, 17B, and 18B are plan views illustrating the configuration examples of the attenuator 80. Figs. 16A and 16B illustrate a configuration example of the attenuator 80 provided in the rib waveguide of Fig. 2. Figs. 17A and 17B illustrate a configuration example of the attenuator 80 provided in the thin wire waveguide of Fig. 3. Figs. 18A and 18B illustrate a configuration example of the attenuator 80 provided in a waveguide of the photonic crystal structure of Fig. 4.

As illustrated in Figs. 16A and 16B, the attenuator 80 includes pn junctions 23p and 23n including a p-type impurity layer 23p and an n-type impurity layer 23n in the rib waveguide 23, and pn junctions 24p and 24n including a p-type impurity layer 24p and an n-type impurity layer 24n in the waveguide 24. Furthermore, the attenuator 80 includes a high-concentration p-type impurity layer Dffp electrically connected to the p-type impurity layer 23p and a high-concentration n-type impurity layer Dffn electrically connected to the n-type impurity layer 23n.

The p-type impurity layer Dffp is electrically connected to a pad Pp via a contact CNTp. The n-type impurity layer Dffn is electrically connected to the pad Pn via the contact CNTn. The pad Pp is connected to the ground GND. The pad Pn is connected to the DAC 2 and receives supply of electric power from the DAC 2. Therefore, the attenuator 80 applies a voltage difference to the pn junctions 23p, 23n, 24p, and 24n to deplete the pn junctions 23p, 23n, 24p, and 24n, thereby absorbing and attenuating light. Therefore, the attenuator 80 can modulate (attenuate) the amplitude or phase of the light L2 passing through the waveguides 23 and 24.

As illustrated in Figs. 17A and 17B, the attenuator 80 includes pn junctions 26p and 26n including a p-type impurity layer 26p and an n-type impurity layer 26n in the thin wire waveguide 26. Furthermore, the attenuator 80 includes the high-concentration p-type impurity layer Dffp electrically connected to the p-type impurity layer 26p and the high-concentration n-type impurity layer Dffn electrically connected to the n-type impurity layer 26n.

The p-type impurity layer Dffp is electrically connected to a pad Pp via a contact CNTp. The n-type impurity layer Dffn is electrically connected to the pad Pn via the contact CNTn. A pad Pnp is connected to the ground GND. The pad Pn is connected to the DAC 2 and receives supply of electric power from the DAC 2. Therefore, the attenuator 80 can apply a voltage difference to the pn junctions 26p and 26n to modulate (attenuate) the amplitude or phase of the light L2 passing through the waveguide 26.

As illustrated in Figs. 18A and 18B, the attenuator 80 includes pn junctions 28p and 28n including a p-type impurity layer 28p and an n-type impurity layer 28n in the waveguide 28 having the photonic crystal structure. Furthermore, the attenuator 80 includes the high-concentration p-type impurity layer Dffp electrically connected to the p-type impurity layer 28p and the high-concentration n-type impurity layer Dffn electrically connected to the n-type impurity layer 28n.

The p-type impurity layer Dffp is electrically connected to a pad Pp via a contact CNTp. The n-type impurity layer Dffn is electrically connected to the pad Pn via the contact CNTn. A pad Pnp is connected to the ground GND. The pad Pn is connected to the DAC 2 and receives supply of electric power from the DAC 2. Therefore, the attenuator 80 can apply a voltage difference to the pn junctions 28p and 28n to modulate (attenuate) the amplitude or phase of the light L2 passing through the waveguide 28.

In this manner, the attenuator 80 can also be formed using a material and a manufacturing method used in an existing CMOS manufacturing step. Similarly, the couplers 20 and 90, the splitter 30, the circulator 40, the optical switch distribution network 50, and the prism 70 can also be formed using materials and manufacturing methods used in existing CMOS manufacturing steps. Therefore, the ranging device 1 according to the present embodiment enables a photonic integrated circuit and the electronics circuit of the FMCW method to be formed on one semiconductor substrate (for example, a silicon substrate) using existing CMOS manufacturing steps. Therefore, it is not necessary to insert laser light from another device, and the insertion loss can be reduced. As a result, the ranging device 1 according to the present embodiment can suppress an electric power loss and a decrease in the SNR, and can perform the highly accurate distance measurement processing.

Furthermore, the grating array 60 can two-dimensionally emit the first light L1 via the prism 70. The emission angle θ of the first light L1 from the Z direction to the X direction can be controlled by changing the wavelength λ of the first light L1.

In the present embodiment, the grating array 60 serves as both a transmission antenna that emits the first light L1 and a reception antenna that receives the reflected light L3. Thus, a chip size of the ranging device 1 can be reduced.

(Second Embodiment)

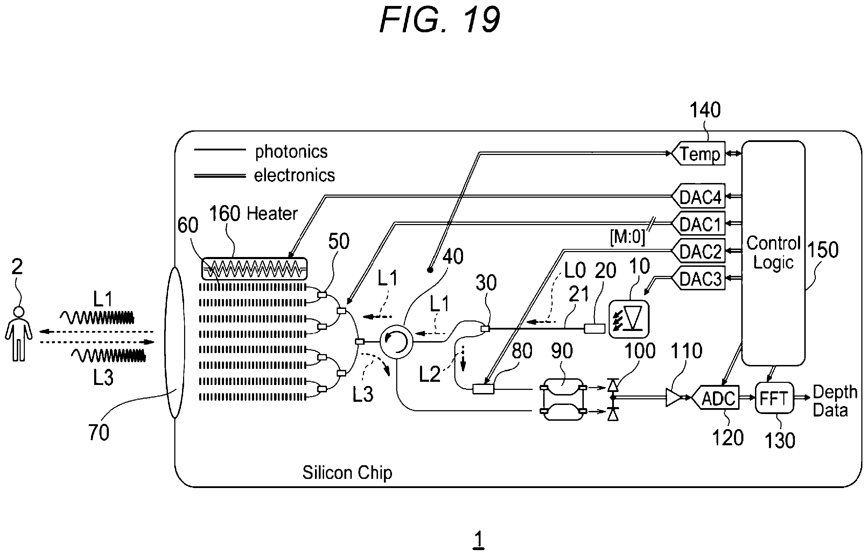

Fig. 19 is a block diagram illustrating a configuration example of the ranging device 1 according to a second embodiment. The second embodiment is different from the first embodiment in terms of further including a heater 160 that heats the grating array 60 and a DAC 4 as a power supply control section that controls supply of electric power to the heater 160.

The heater 160 receives the supply of electric power from the DAC 4 and heats the grating array 60. The DAC 4 receives a digital control signal of the logic control circuit 150, and controls an output of the heater 160 according to the digital control signal. Therefore, the heater 160 can control a temperature of the grating array 60.

As described above, the refractive index N of a substance changes depending on a temperature of the substance. For example, the refractive index N of the rib or thin wire waveguides 23 and 26 (for example, silicon) changes from 4 to 20 as the temperature increases to 2000 °C. Furthermore, the refractive index N of the waveguide 28 (for example, silicon) having a photonic crystal structure can be changed from 4 to 20 by heating to about 400 °C. In this manner, the refractive index N of the substance changes depending on the temperature of the substance. In the second embodiment, the emission angle θ of the first light L1 is controlled using this characteristic. In particular, when the photonic crystal structure is used, the refractive index N of the substance (for example, silicon) can be greatly changed by the temperature. Thus, the photonic crystal structure can improve controllability by the temperature of the refractive index N of the substance.

The refractive index N is inversely proportional to a light speed C and the wavelength λ in the substance from Formula 1. Thus, when the refractive index N of the waveguide 26 becomes twenty, the light speed C and the wavelength λ in the waveguide 26 become 1/20 of a light speed and a wavelength in vacuum.

In the second embodiment, the heater 160 controls the refractive index N of the grating array 60 by controlling the temperature of the grating array 60. When the refractive index N is controlled, the emission angle θ of the first light L1 can be controlled from Formulas 1 and 4 as described above. In particular, in a case where the grating array 60 has the photonic crystal structure, the refractive index N can be greatly changed by the temperature control. Therefore, the grating array 60 having the photonic crystal structure can easily control the emission angle θ of the first light L1 by the temperature control.

Other configurations of the second embodiment may be the same as those of the first embodiment. Therefore, the second embodiment can obtain effects similar to those of the first embodiment.

(Third Embodiment)

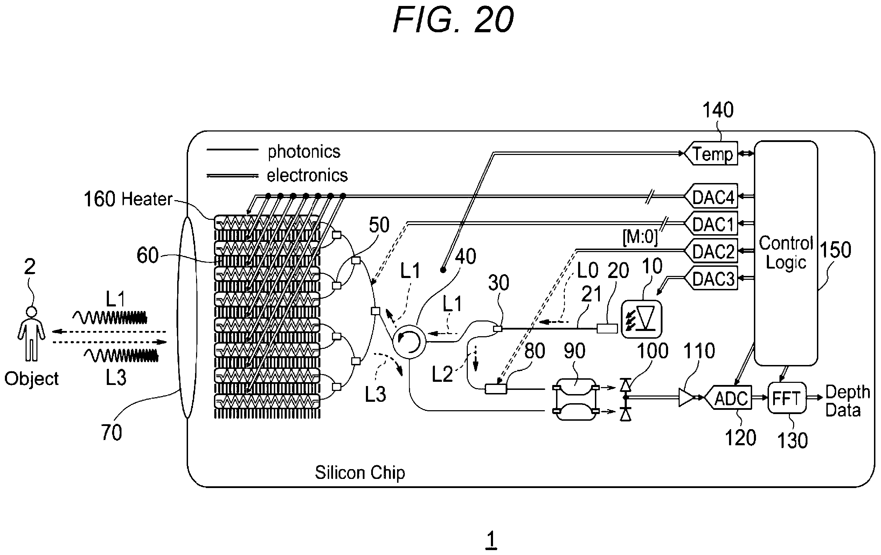

Fig. 20 is a block diagram illustrating a configuration example of the ranging device 1 according to a third embodiment. In the third embodiment, the heater 160 is provided corresponding to each of the plurality of waveguides 26 of the grating array 60. Therefore, the number of the heaters 160 may be substantially the same as the number of the waveguides 26 of the grating array 60. Accordingly, the number of the DACs 4 is the same as the number of the heaters 160. Other configurations of the third embodiment may be similar to those of the second embodiment.

Therefore, the DAC 4 can drive some heaters 160 to heat only a part of the grating array 60 corresponding thereto. Therefore, a refractive index of the waveguide 26 in a part of the grating array 60 can be made different from a refractive index of the other waveguides 26. Therefore, the emission angle θ of the first light L1 in a part of the grating array 60 can be made different from the emission angle θ in the other part. Therefore, the controllability of the first light L1 is improved.

Furthermore, since the heater 160 is provided to correspond to each of the waveguides 26, the entire grating array 60 can be heated to perform the temperature.

Other configurations of the third embodiment may be the same as those of the second embodiment. Therefore, the third embodiment can obtain effects similar to those of the second embodiment.

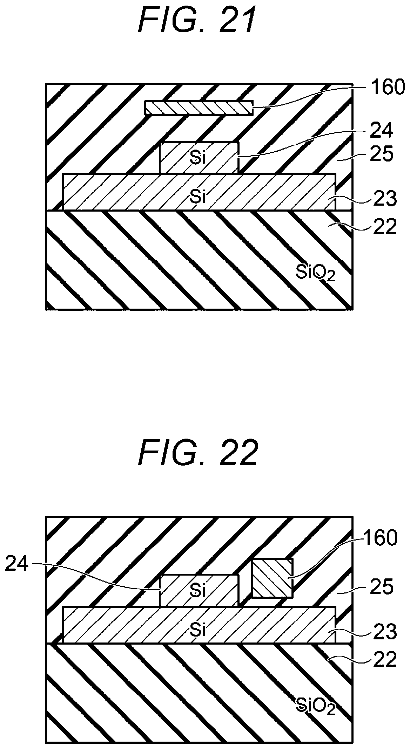

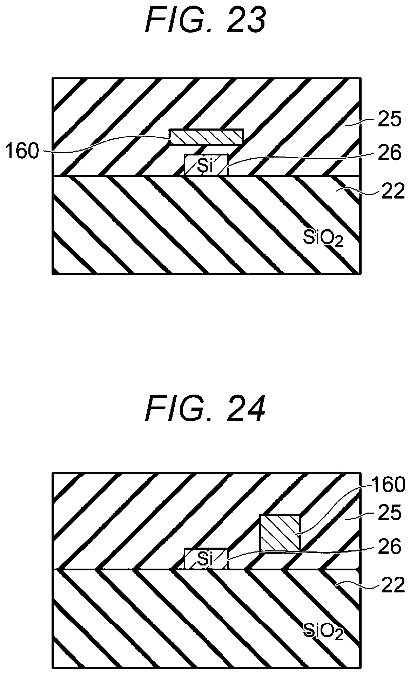

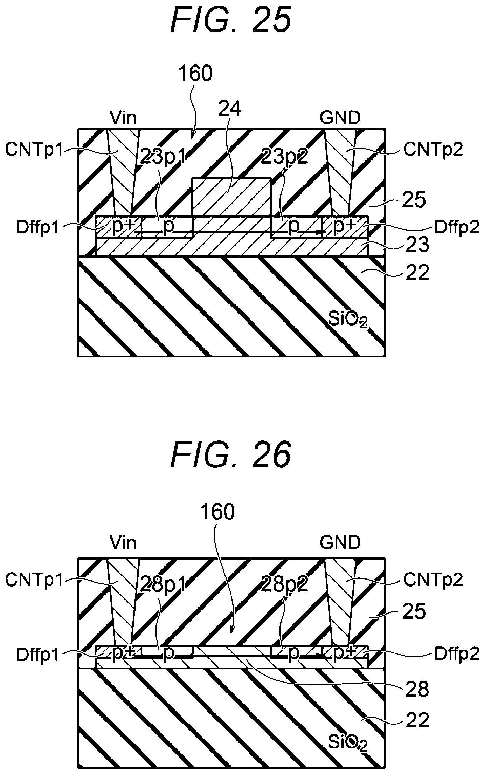

Figs. 21 to 26 are cross-sectional views illustrating configuration examples of the heater 160. Figs. 21 and 22 illustrate the heater 160 provided in the rib waveguides 23 and 24. Figs. 23 and 24 illustrate the heater 160 provided in the thin wire waveguide 26. Figs. 25 and 26 illustrate the heater 160 provided in the waveguide 28 of a photonic crystal structure.

The heater 160 in Fig. 21 is provided above the rib waveguides 23 and 24, and is provided in the insulating film 25. The heater 160 is a flat metal plate extending along the waveguides 23 and 24 and having a length substantially equal to or longer than those of the waveguides 23 and 24. A width of the heater 160 is slightly wider than a width of the waveguide 24 but narrower than a width of the waveguide 23. A cross section (a cross section perpendicular to an extending direction) of the heater 160 may be substantially rectangular. The heater 160 is made of, for example, a metal material such as TiN, and generates heat by electric power supplied from the DAC 4.

The heater 160 in Fig. 22 is provided above the rib waveguide 23 and on the side of the waveguide 24, and is provided in the insulating film 25. The heater 160 is a metal rod extending along the waveguides 23 and 24 and having a length substantially equal to or longer than that of the waveguides 23 and 24. A cross section (a cross section perpendicular to an extending direction) of the heater 160 may be substantially square. A width of the heater 160 is narrower than widths of the waveguides 23 and 24. A material of the heater 160 may be the same as that of Fig. 21.

The heater 160 in Fig. 23 is provided above the thin wire waveguide 26 and is provided in the insulating film 25. The heater 160 is a flat metal plate extending along the waveguide 26 and having a length substantially equal to or longer than that of the waveguide 26. A width of the heater 160 is slightly wider than a width of the waveguide 26. A cross section (a cross section perpendicular to an extending direction) of the heater 160 may be substantially rectangular. A material of the heater 160 may be the same as that of Fig. 21.

The heater 160 in Fig. 24 is provided on the side of the waveguide 26 and is provided in the insulating film 25. The heater 160 is a metal rod extending along the waveguide 26 and having a length substantially equal to or longer than that of the waveguide 26. A cross section (a cross section perpendicular to an extending direction) of the heater 160 may be substantially square. A material of the heater 160 may be the same as that of Fig. 21.

The heater 160 of Fig. 25 is provided in the rib waveguides 23 and 24, and heats the waveguide 23 by causing a current to flow in the waveguide 23 itself. For example, the waveguides 23 on both sides of the waveguide 24 are provided with p-type impurity layers 23p1 and 23p2, respectively. A waveguide 23 (for example, intrinsic silicon) is interposed between the p-type impurity layer 23p1 and the p-type impurity layer 23p2. The p-type impurity layers 23p1 and 23p2 and the waveguide 23 have a PiP (p-type-intrinsic-p-type) silicon structure. Furthermore, in the p-type impurity layers 23p1 and 23p2, a high-concentration p-type impurity layer Dffp1 connected to the p-type impurity layer 23p1 and a high-concentration p-type impurity layer Dffp2 connected to the p-type impurity layer 23p2 are provided.

A contact CNTp1 is provided on the p-type impurity layer Dffp1, and a contact CNTp2 is provided on the p-type impurity layer Dffp2. The contact CNTp1 is connected to a power supply Vin, and the contact CNTp2 is connected to the ground GND. Therefore, a voltage of the power supply Vin is applied between the p-type impurity layer 23p1 and the p-type impurity layer 23p2. As a result, a current flows through the waveguide 23 (PiP silicon structure) between the p-type impurity layer 23p1 and the p-type impurity layer 23p2, thereby generating heat. In this manner, a heater may be provided in the waveguide 23. Note that the heater may be similarly provided in the waveguide 24.

The heater 160 of Fig. 26 is provided in the waveguide 28 having the photonic crystal structure, and applies a current to the waveguide 28 itself to heat the waveguide 28. For example, p-type impurity layers 28p1 and 28p2 are provided on both sides of the waveguide 28. The waveguide 28 (for example, intrinsic silicon) is interposed between the p-type impurity layer 28p1 and the p-type impurity layer 28p2. The p-type impurity layers 28p1 and 28p2 and the waveguide 28 have a PiP silicon structure. Furthermore, in the p-type impurity layers 28p1 and 28p2, a high-concentration p-type impurity layer Dffp1 connected to the p-type impurity layer 28p1 and a high-concentration p-type impurity layer Dffp2 connected to the p-type impurity layer 28p2 are provided.

A contact CNTp1 is provided on the p-type impurity layer Dffp1, and a contact CNTp2 is provided on the p-type impurity layer Dffp2. The contact CNTp1 is connected to a power supply Vin, and the contact CNTp2 is connected to the ground GND. Therefore, a voltage of the power supply Vin is applied between the p-type impurity layer 28p1 and the p-type impurity layer 28p2. As a result, a current flows through the waveguide 28 (PiP silicon structure) between the p-type impurity layer 28p1 and the p-type impurity layer 28p2, thereby generating heat. In this manner, a heater may be provided in the waveguide 28.

The heaters 160 of Figs. 21 and 23 are relatively simple to manufacture since it is only required to form a metal material layer above the waveguide 23, 24, or 26.

Since the heater 160 of Fig. 22 can perform heating from a side surface of the waveguide 24 and a surface of the waveguide 23, the rib waveguides 23 and 24 can be efficiently heated. Furthermore, the heater 160 of Fig. 24 can also perform heating from a side surface of the waveguide 26.

The heaters 160 of Figs. 25 and 26 are provided in the waveguides 23 and 28, respectively, and have the PiP silicon structure. Since the PiP silicon structure directly heats the waveguides 23 and 28, the waveguides can be heated more efficiently and in a short time.

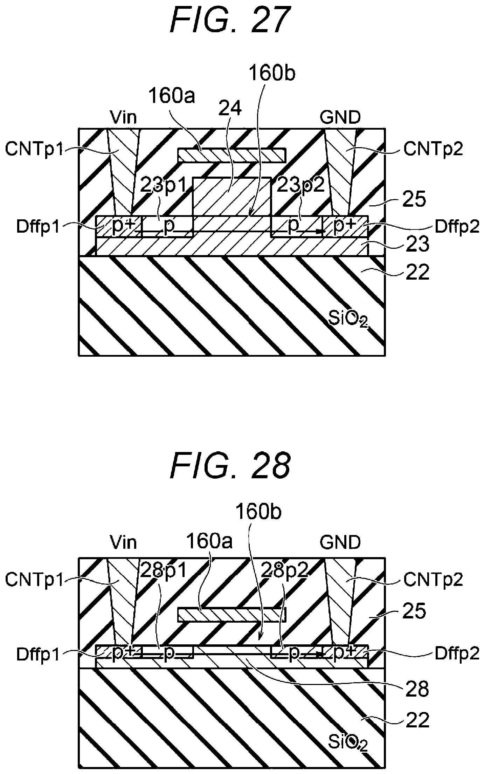

The heater 160 of Fig. 21 or Fig. 23, the heater 160 of Fig. 22 or Fig. 24, and the heater 160 of Fig. 25 or Fig. 26 may be combined. For example, Fig. 27 is an example in which the heater 160 of Fig. 21 is combined with the heater 160 of Fig. 25. Fig. 28 is an example in which the heater 160 of Fig. 21 is combined with the heater 160 of Fig. 26. In this case, the waveguides 23 and 24 can be heated more efficiently and at a higher speed by a plurality of heaters 160a and 160b. The heater 160b having a PiP silicon structure or a photonic crystal structure immediately heats the waveguides 23 and 24 or the waveguide 28 in a short time, and the heater 160a such as a metal film performs fine temperature control (temperature offset correction) of the waveguides 23 and 24 or the waveguide 28. Furthermore, the temperature control varies due to variation in impurity concentration in the PiP silicon structure or the photonic crystal structure. The heater 160a may be used to correct such variation in temperature control of the heater 160b and finely adjust the temperature.

It is a matter of course that the heater 160 of Fig. 25 or 26 may be combined with the heater 160 of Fig. 22 or Fig. 24. The heater 160 of Fig. 21 or Fig. 23 may be combined with the heater 160 of Fig. 22 or 24.

(Fourth Embodiment)

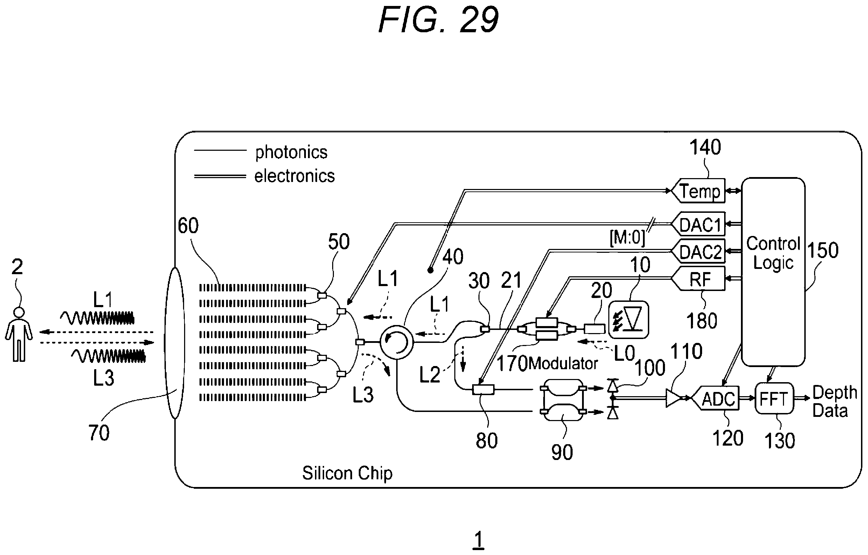

Fig. 29 is a block diagram illustrating a configuration example of a ranging device according to a fourth embodiment. The fourth embodiment further includes a modulator 170 that modulates a frequency of the laser light L0 and a high frequency generating circuit 180 that gives an electrical high-frequency signal to the modulator 170. The modulator 170 is provided in a photonic circuit, and the high frequency generating circuit 180 is provided in an electric circuit.

Modulation of the laser light L0 can be executed by changing a current with respect to the laser light source 10 or a temperature. However, in this case, the modulation of the laser light L0 in the laser light source 10 is inferior in responsiveness. On the other hand, when the modulator 170 and the high frequency generating circuit 180 are provided on a semiconductor chip separately from the laser light source 10, the modulator 170 can modulate the laser light L0 at high speed by the high-frequency signal from the high frequency generating circuit 180. Therefore, the fourth embodiment is excellent in high-speed responsiveness for the modulation of the laser light L0. Furthermore, if the laser light L0 is modulated using a technique such as encoding in the modulator 170, the ranging device 1 can suppress interference (crosstalk) with other ranging devices. Note that the laser light source 10 is only required to output the laser light L0 having a predetermined frequency without modulation in the fourth embodiment.

Other configurations of the fourth embodiment may be similar to those of the first embodiment. Therefore, the fourth embodiment can obtain effects similar to those of the first embodiment. Furthermore, the fourth embodiment may be combined with the second or third embodiment.

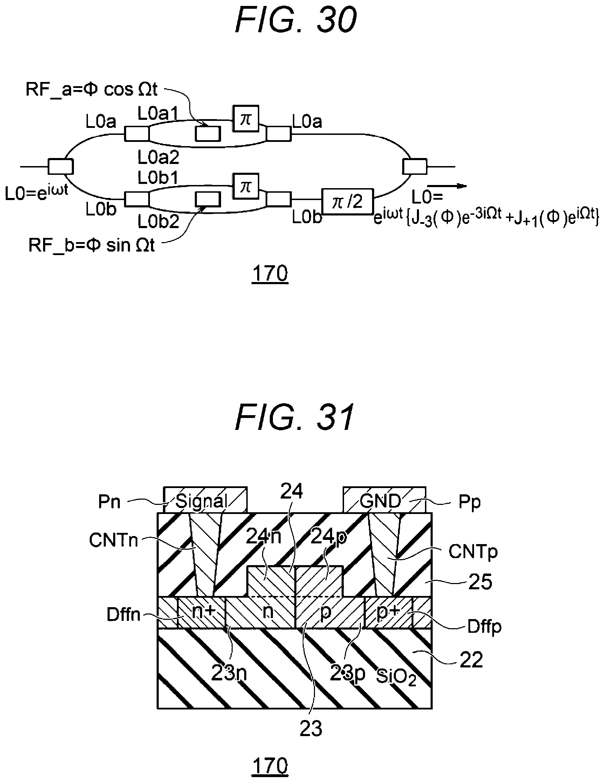

Fig. 30 is a diagram illustrating a configuration example of the modulator 170. The modulator 170 may be a single side band (SSB) modulator using a carrier plasma effect. The modulator 170 splits the laser light L0 into beams of laser light L0a and L0b by a splitter, and further splits each of beams of the laser light L0a and L0b into two beams (L0a1, L0a2, L0b1, and L0b2) by another splitter. The modulator 170 electrically gives a high-frequency signal RF_a to beams of laser light L0a1 and L0a2, and electrically gives a high-frequency signal RF_b to the other beams of laser light L0b1 and L0b2. A phase difference between the high-frequency signal RF_a and the high-frequency signal RF_b is n/2. Therefore, phases of two beams of the laser light L0a and L0b change from each other. Moreover, a phase difference $\pi$ is given to one L0a1 of the two split beams of laser light, and a phase difference $\pi$ is given to one L0b1 of the two split beams of laser light. Then, beams of the laser light L0a1 and L0a2 are coupled by a coupler, and beams of the laser light L0b1 and L0b2 are coupled by a coupler. A phase difference n/2 is further given to the laser light L0b after coupling, and beams of the laser light L0a and L0b after coupling are coupled by a coupler. Therefore, the modulator 170 outputs the laser light L0 whose phase and frequency have been modulated.

For example, when the input laser light L0a is $e^{iwt}$, the high-frequency signal RF_a is $\Phi\cos(\Omega t)$, and RF_b is $\Phi\sin(\Omega t)$, the modulated laser light L0 is $e^{iwt}\{j_{-3}(\Phi)e^{-3i\Omega t} + j_{+1}(\Phi)e^{i\Omega t}\}$. Here, $\Phi$ is an amplitude of each of RF_a and RF b. Q corresponds to a frequency modulation width determined by RF a and RF_b, and t is time. $j_{-3}$ and $j_{+1}$ represent a negative third harmonic and a positive first harmonic components, respectively.

Fig. 31 is a cross-sectional view illustrating a configuration example of a region of the modulator 170 to which a high-frequency signal is applied. The modulator 170 includes the pn junctions 23p and 23n including the p-type impurity layer 23p and the n-type impurity layer 23n in the rib waveguide 23, and the pn junctions 24p and 24n including the p-type impurity layer 24p and the n-type impurity layer 24n in the waveguide 24. Furthermore, the modulator 170 includes the high-concentration p-type impurity layer Dffp electrically connected to the p-type impurity layer 23p and the high-concentration n-type impurity layer Dffn electrically connected to the n-type impurity layer 23n.

The p-type impurity layer Dffp is electrically connected to a pad Pp via a contact CNTp. The n-type impurity layer Dffn is electrically connected to the pad Pn via the contact CNTn. The pad Pp is connected to the ground GND. The pad Pn is connected to the high frequency generating circuit 180 and receives the high-frequency signal RF_a or RF_b from the high frequency generating circuit 180. Therefore, the modulator 170 applies the high-frequency signal RF a or RF_b to the pn junction in the waveguides 23 and 24, thereby modulating a phase or a frequency of the laser light (L0a1 and L0a2 or L0b1 and L0b2). Therefore, the modulator 170 can modulate the phase or frequency of the laser light L0 passing through the waveguides 23 and 24.

The modulator 170 is also made of an SOI layer (silicon single crystal), and can be formed using a material and a manufacturing method used in an existing CMOS manufacturing step.

Fig. 31 illustrates the modulator 170 provided in the rib waveguides 23 and 24. However, the modulator 170 may be provided in the thin wire waveguide 26 or the waveguide 28 having a photonic crystal structure.

(Fifth Embodiment)

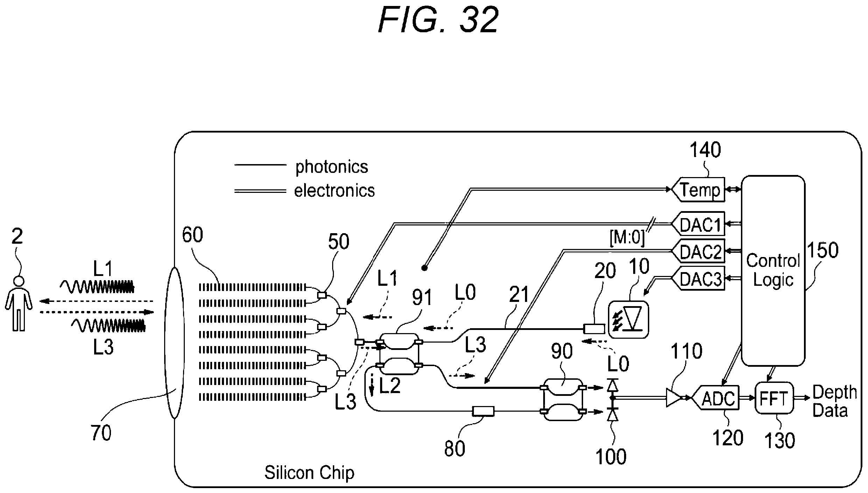

Fig. 32 is a block diagram illustrating a configuration example of a ranging device according to a fifth embodiment. In the fifth embodiment, a 2 × 2 coupler 91 is provided instead of the circulator 40 and the splitter 30. The 2 × 2 coupler 91 receives an input of the laser light L0 and splits the laser light L0 into beams of the laser light L1 and L2. The first light L1 is transmitted to the target 2 via the grating array 60. The laser light L2 is transferred to the attenuator 80 via a waveguide. The attenuator 80 attenuates the laser light L2 and outputs the attenuated laser light L2 to the 2 × 2 coupler 90. Furthermore, the 2 × 2 coupler 91 outputs reflected light L3 received by the grating array 60 to the 2 × 2 coupler 90.

The 2 × 2 coupler 90 combines the laser light L2 and the reflected light L3 to output a composite wave. The subsequent operation of the ranging device 1 is the same as the operation of the first embodiment. In this manner, by effectively using all input/output ports of the two 2 × 2 couplers 90 and 91, a part of the laser light L2 split from the laser light L0 can be combined with the reflected light L3 as original laser light. That is, the laser light L0 can be used without waste.

The 2 × 2 coupler 90 does not require special material (for example, yttrium iron garnet or the like) and structure like a circulator, and can be formed in a waveguide formed on a silicon wafer. Therefore, the fifth embodiment can be easily formed using a material and a manufacturing method used in a CMOS manufacturing step.

(Sixth Embodiment)

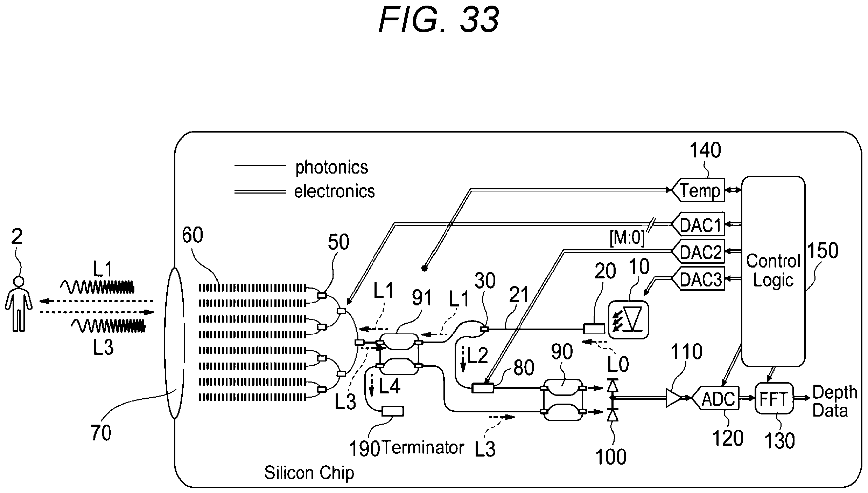

Fig. 33 is a block diagram illustrating a configuration example of a ranging device according to a sixth embodiment. The sixth embodiment is similar to the fifth embodiment in that the 2 × 2 coupler 91 is provided instead of the circulator 40. However, the sixth embodiment includes the splitter 30, and the splitter 30 splits the laser light L0 into beams of the laser light L1 and L2. The beams of laser light L1 and L2 are used similarly as in the first embodiment.

On the other hand, the 2 × 2 coupler 91 receives an input of the laser light L1 and splits a part of the laser light L1 as laser light L4. The laser light L4 is terminated by a terminator 190 via a waveguide. The terminator 190 is connected to one terminal of the 2 × 2 coupler 91. The terminator 190 may be, for example, a PN attenuator or a photodetector. In a case where the terminator 190 is the PN attenuator, the terminator 190 attenuates and terminates the laser light L4. In a case where the terminator 190 is the photodetector, the terminator 190 is used as a signal intensity monitor and can detect the laser light L4.

The remaining laser light (third light) L1 excluding the laser light L4 is transmitted to the target 2 via the grating array 60.

The laser light L2 is transferred to the attenuator 80. The attenuator 80 attenuates the laser light L2 to any level and outputs the attenuated laser light L2 to the 2 × 2 coupler 90. Furthermore, the 2 × 2 coupler 91 outputs reflected light L3 received by the grating array 60 to the 2 × 2 coupler 90.

Other configurations of the sixth embodiment may be similar to those of the fifth embodiment. Therefore, the sixth embodiment can obtain effects similar to those of the fifth embodiment. Furthermore, the terminator 190 terminates one end of the 2 × 2 coupler 91, and thus, crosstalk with the reflected light L3 in the coupler 91 due to reflection of the laser light L4 can be suppressed.

(Seventh Embodiment)

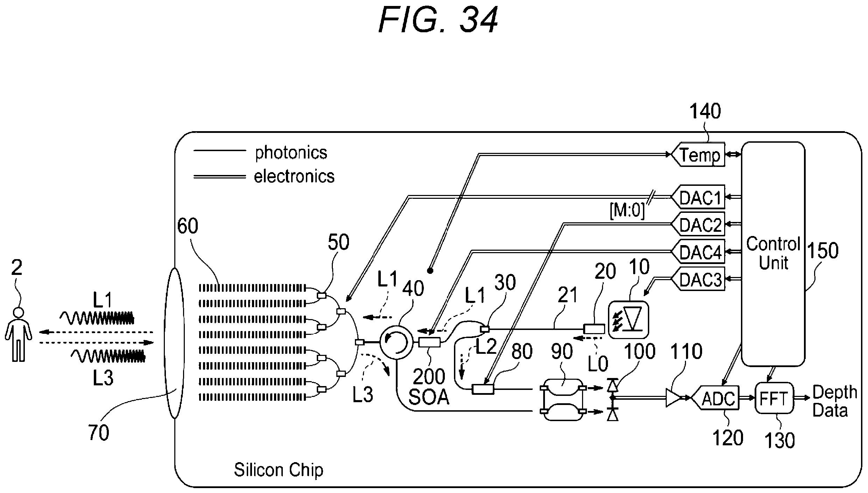

Fig. 34 is a block diagram illustrating a configuration example of a ranging device according to a seventh embodiment. The seventh embodiment further includes: an optical amplifier (semiconductor optical amplifier (SOA)) 200 provided between the splitter 30 and the circulator 40; and the DAC 4 that supplies electric power to the optical amplifier 200. The optical amplifier 200 is provided in a photonic integrated circuit, and the DAC 4 is provided in an electronics circuit.

The optical amplifier 200 optically amplifies the laser light L1 transmitted from the grating array 60 and supplies the laser light L1 to the circulator 40. Therefore, it is possible to compensate for an insertion loss of the laser light L0 inserted from the laser light source 10 into the coupler 20.

It is also conceivable to increase an output of the laser light source 10 in order to increase power of the laser light L0. However, an excessively high output of the laser light source 10 leads to damage of the coupler 20. Therefore, there is an upper limit to the output of the laser light source 10.

In regard to this, in the seventh embodiment, the laser light L1 can be amplified since the optical amplifier 200 is provided in a waveguide between the splitter 30 and the circulator 40. Therefore, it is possible to compensate for the insertion loss of the laser light L0 from the laser light source 10 to the coupler 20 while maintaining the output of the laser light source 10 low. Furthermore, since the optical amplifier 200 is used, it is also possible to use an optical circuit element such as a modulator having a large optical loss. Furthermore, the optical amplifier may be formed using a compound semiconductor (InGaAs, InP, or the like).

Note that the optical amplifier 200 may be provided in any waveguide from the circulator 40 to the optical switch distribution network 50. Furthermore, the number of the optical amplifiers 200 is not limited, and may be two or more.

(Eighth Embodiment)

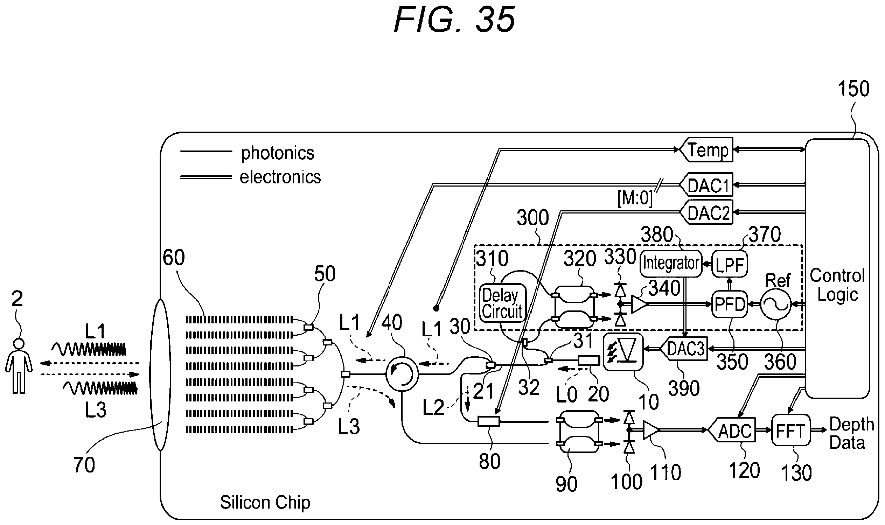

Fig. 35 is a block diagram illustrating a configuration example of a ranging device according to an eighth embodiment. The eighth embodiment further includes: a feedback (optical phase-lock loop (PLL)) circuit 300 that feeds back a part of the laser light L0 to stabilize a frequency of the laser light L0; and splitters 31 and 32 that split the part of the laser light L0 in order to input the part of the laser light L0 to the feedback circuit 300. The feedback circuit 300 is provided to control an output from the DAC 3 to the laser light source 10 by performing feedback correction of a change (fluctuation (jitter)) in a phase of the laser light L0 from the laser light source 10.

The splitter 31 splits a part of the laser light L0 and sends the split laser light L0 to the feedback circuit 300, and sends the remaining laser light L0 to the splitter 30. Configurations subsequent to the splitter 30 may be similar to those of the first embodiment.

The splitter 32 further splits the part of the laser light L0 split by the splitter 31 and inputs the split laser light L0 to the feedback circuit 300.

The feedback circuit 300 includes a delay circuit 310, a $2 \times 2$ coupler 320, a BPD 330, a TIA 340, a phase frequency detector (PFD) 350, a low pass filter (LPF) 370, and an integrator circuit 380. The delay circuit 310, the $2 \times 2$ coupler 320, and the BPD 330 are included in a photonic circuit, and the TIA 340, the PFD 350, the LPF 370, and the integrator circuit 380 are included in an electronics circuit.

The delay circuit 310 receives a part of the laser light L0 split by the splitter 32 and optically delays the part of the laser light L0.

The $2 \times 2$ coupler 320 receives the part of the laser light L0 delayed by the delay circuit 310 and the remaining laser light L0 that has been split by the splitter 32 and is not delayed, and combines these beams of light to output a composite wave. The BPD 330 receives an input of the composite wave from the $2 \times 2$ coupler 320 and performs photoelectric conversion into an electric signal. In the BPD 330, a difference frequency proportional to a delay amount of a part of the laser light L0 in the delay circuit 310 is output as the electric signal. The TIA 340 amplifies the electric signal from the BPD 330. That is, the $2 \times 2$ coupler 320, the BPD 330, and the TIA 340 function similarly to the $2 \times 2$ coupler 90, the BPD 100, and the TIA 120, and can detect the difference frequency of the composite wave.

The PFD 350 receives an input of the difference frequency of the electric signal from the BPD 330, receives an input of a reference signal corresponding to a known delay amount from the logic control circuit 150, compares them, and outputs a comparison result (beat frequency, difference frequency) between the electric signal and the reference signal.

The comparison result from the PFD 350 is subjected to removal of a low frequency component through the LPF 370 and integral in the integrator circuit 380 to control the DAC 3 that supplies electric power to the laser light source 10. Therefore, an output of the laser light source 10 is feedback-controlled, and the phase fluctuation (jitter) of the laser light L0 can be reduced. In this manner, according to the eighth embodiment, it is possible to improve coherence of the phase of the laser light L0, which is important in an FMCW method, and to improve distance measurement performance over a long distance.

Other configurations of the eighth embodiment may be similar to those of the first embodiment. Therefore, the eighth embodiment can also obtain the effect of the first embodiment.

(Ninth Embodiment)

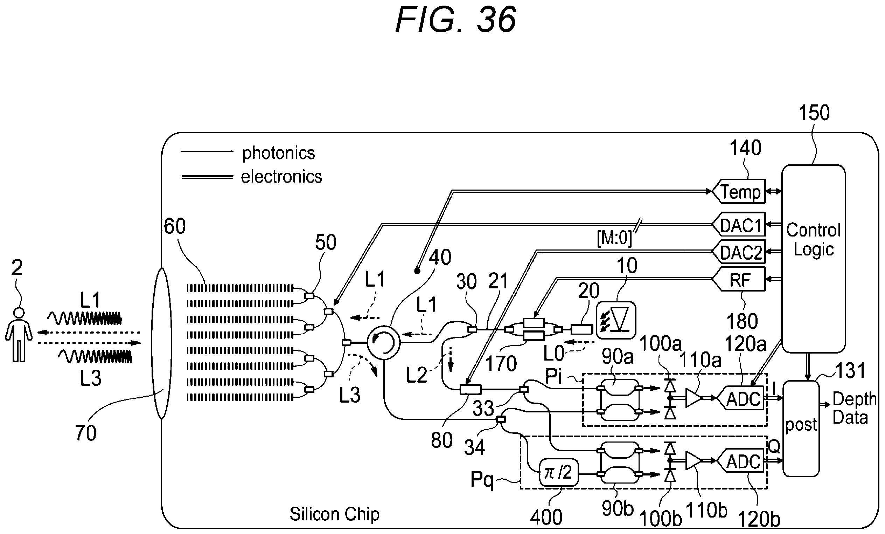

Fig. 36 is a block diagram illustrating a configuration example of a ranging device according to a ninth embodiment. In the ninth embodiment, the received reflected light L3 is split into a plurality of beams. It is assumed that one split reflected light L3 is an I component whose phase is not shifted, and the other reflected light L3 is a Q component whose phase is shifted by n/2. The ranging device 1 performs signal processing separately on the reflected light L3 of the I component and the reflected light L3 of the Q component. For this purpose, the ranging device 1 further includes: splitters 33 and 34; a signal processing circuit Pi that performs processing on the reflected light L3 of the I component; and a signal processing circuit Pq that performs processing on the reflected light L3 of the Q component.

The splitter 33 receives the laser light L2 via the attenuator 80, splits the laser light L2, and gives the split laser light L2 to each of the signal processing circuits Pi and Pq. The splitter 34 receives the reflected light L3 from the circulator 40, splits the reflected light L3, and gives the split reflected light L3 to each of the signal processing circuits Pi and Pq.

The signal processing circuit Pi includes a 2 × 2 coupler 90a, a BPD 100a, a TIA 110a, and an ADC 120a. The signal processing circuit Pq includes a phase modulation circuit 400, a 2 × 2 coupler 90b, a BPD 100b, a TIA 110b, and an ADC 120b. The 2 × 2 couplers 90a and 90b, the BPDs 100a and 100b, the TIAs 110a and 110b, and the ADCs 120a and 120b may have the same configurations as the 2 × 2 coupler 90, the BPD 100, the TIA 110, and the ADC 120 of the first embodiment, respectively.

The 2 × 2 coupler 90a of the signal processing circuit Pi receives a part of the laser light L2 from the splitter 33 and a part of the reflected light L3 from the splitter 34, and combines them to generate a composite wave of the I component. The signal processing circuit Pi further converts a difference frequency of the composite wave of the I component into an electrical signal by the BPD 100a, the TIA 110a, and the ADC 120a, and outputs the electrical signal to the signal processing circuit 131.

The signal processing circuit Pq includes the phase modulation circuit 400 that shifts a phase of the reflected light L3 from the splitter 34 by $\pi/2$ (90 degrees). Therefore, the 2 × 2 coupler 90b receives the other part of the laser light L2 from the splitter 33 and the other part of the reflected light L3 whose phase has been modulated by $\pi/2$, and combines them to generate a composite wave of the Q component. The signal processing circuit Pq further converts a difference frequency of the composite wave of the Q component into an electrical signal by the BPD 100b, the TIA 110b, and the ADC 120b, and outputs the electrical signal to the signal processing circuit 131. The signal processing circuit 131 receives the electric signals of the I component and the Q component, and executes distance measurement processing such as FFT.

In this manner, since the ranging device 1 separates the reflected light L3 into the I component and the Q component and process these components, it is possible to suppress noise and improve distance resolution and an SNR. Furthermore, since the reflected light L3 is separated into the I component and the Q component and processed, it is possible to suppress the influence of coherence of a phase of the laser light L0 on distance measurement performance.

Other configurations of the ninth embodiment may be similar to those of the fourth embodiment. Therefore, the ninth embodiment can also obtain the effect of the fourth embodiment. The ninth embodiment may be combined with the other embodiments described above. Note that the 2 × 2 couplers 90a and 90b may be integrated hybrid couplers.

(Tenth Embodiment)

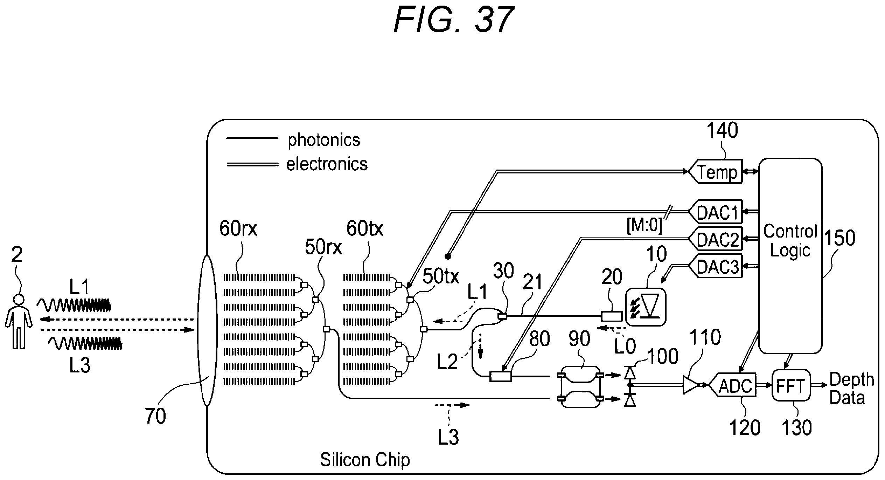

Fig. 37 is a block diagram illustrating a configuration example of a ranging device according to a tenth embodiment. In the tenth embodiment, the grating array 60 is divided into a transmission array 60tx and a reception array 60rx. Accordingly, the optical switch distribution network 50 is also divided into an optical switch distribution network 50tx for transmission and an optical switch distribution network 50rx for reception.

The ranging device 1 includes: the transmission array 60tx that transmits the laser light L1; an optical switch distribution network 50tx that distributes the laser light L1 transmitted from the transmission array 60tx; a reception array 60rx that receives the reflected light L3; and an optical switch distribution network 50rx that collects the reflected light L3 received by the reception array 60rx and sends the collected reflected light L3 to the 2 × 2 coupler 90.

Since the grating array 60 is divided into the transmission array 60tx and the reception array 60rx, the circulator 40 can be omitted. Therefore, a loss of the laser light L1 in the circulator 40 can be suppressed.

The transmission array 60tx and the reception array 60rx preferably have an X axis and a Y axis in common in a planar layout (layout of X-Y plane in Fig. 13). That is, it is preferable that waveguides of the transmission array 60tx and the reception array 60rx have the same extending direction (X direction), and waveguides of the transmission array 60tx and the reception array 60rx have the same array direction or grating extending direction (Y direction). Therefore, optical systems subsequent to the prism 70 can be coaxial between the transmission array 60tx and the reception array 60rx. Therefore, the optical systems subsequent to the prism 70 can be shared as one system. In this case, it is sufficient to provide one prism 70 between the transmission array 60tx and the reception array 60rx.

Furthermore, typically, the reflected light L3 is degraded more than the original laser light L1. Thus, in order to increase the reception sensitivity of the reflected light L3, it is preferable to set a length of the reception array 60rx in the X direction to be longer than that of the transmission array 60tx, or set the number of arrays (a length in the Y direction) of the reception array 60rx to be larger than that of the transmission array 60tx. Therefore, a planar size of the reception array 60rx is larger than that of the transmission array 60tx, and thus, the reception sensitivity of the reception array 60rx can be improved.

Other configurations of the tenth embodiment may be similar to those of the first embodiment. Therefore, the tenth embodiment can also obtain the effect of the first embodiment. The tenth embodiment may be combined with the other embodiments described above.

(Eleventh Embodiment)

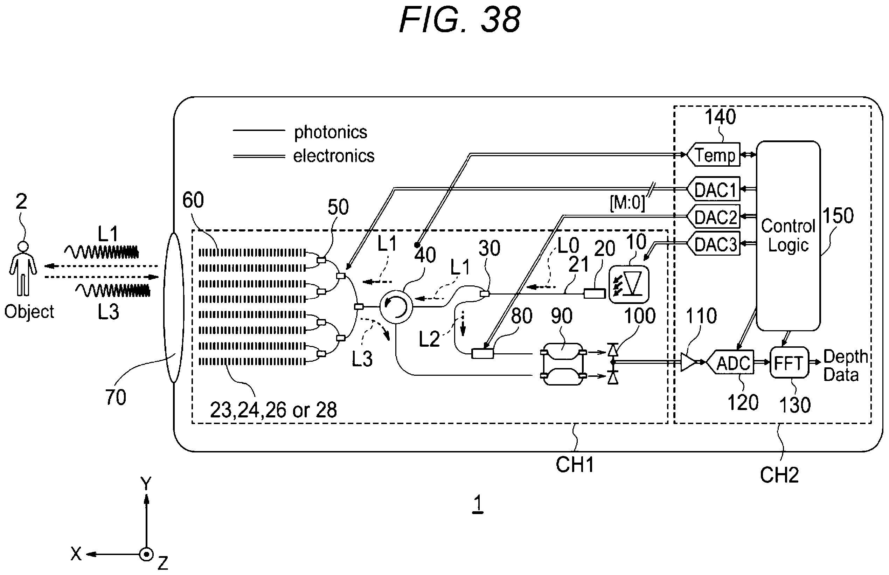

Fig. 38 is a block diagram illustrating a configuration example of a ranging device according to an eleventh embodiment. A ranging device 1 according to the eleventh embodiment includes a first semiconductor substrate CH1 and a second semiconductor substrate CH2 that are laminated. The first semiconductor substrate CH1 includes a photonic circuit, and the second semiconductor substrate CH2 includes another electronics circuit (analog-digital mixed circuit).

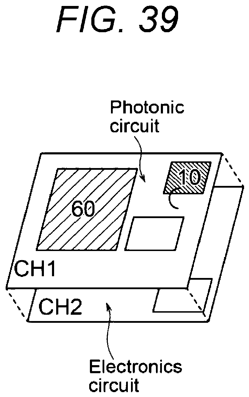

Fig. 39 is a conceptual diagram illustrating a laminated state of the first and second semiconductor substrates CH1 and CH2. The photonic circuit including the grating array 60 that emits the laser light L1 and receives the reflected light L3 is laminated, as the upper semiconductor substrate CH1, on the lower semiconductor substrate CH2 including a logic circuit.

The first semiconductor substrate CH1 and the second semiconductor substrate CH2 have substantially the same planar size, and are laminated such that the entire first semiconductor substrate CH1 overlaps the entire second semiconductor substrate CH2.

It is sufficient to use a through silicon via (TSV) or Cu-Cu bonding for directly bonding a wiring and a wiring for electrical connection between the first semiconductor substrate CH1 and the second semiconductor substrate CH2.

A layout area can be reduced by configuring the ranging device 1 with the laminated first and second semiconductor substrates CH1 and CH2.

Since the photonic circuit and the electronics circuit are formed on the different semiconductor substrates CH1 and CH2, the photonic circuit and the electronics circuit can be manufactured efficiently and at low cost using appropriate manufacturing processes, respectively.

Since the first semiconductor substrate CH1 of the photonic circuit and the second semiconductor substrate CH2 of the electronics circuit are laminated, a physical distance between a control circuit (the electronics circuit) and a controlled circuit (the photonic circuit) becomes short. Therefore, a parasitic capacitance of the wiring (TSV or Cu-Cu junction) decreases, and a control delay is alleviated. Note that the eleventh embodiment may be applied to any of the embodiments described above.

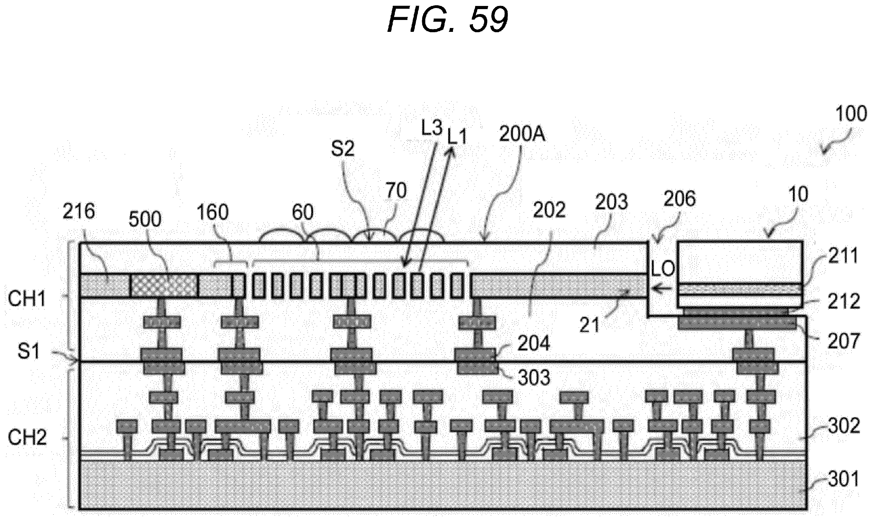

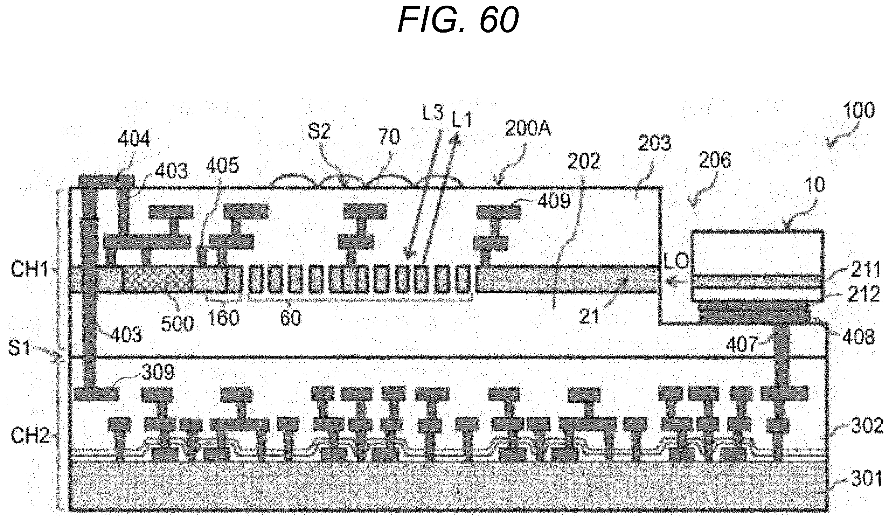

A cross-sectional structure of the eleventh embodiment may be either a laminated structure 1 or a laminated structure 2 illustrated in Fig. 59 or Fig. 60.

(Twelfth Embodiment)

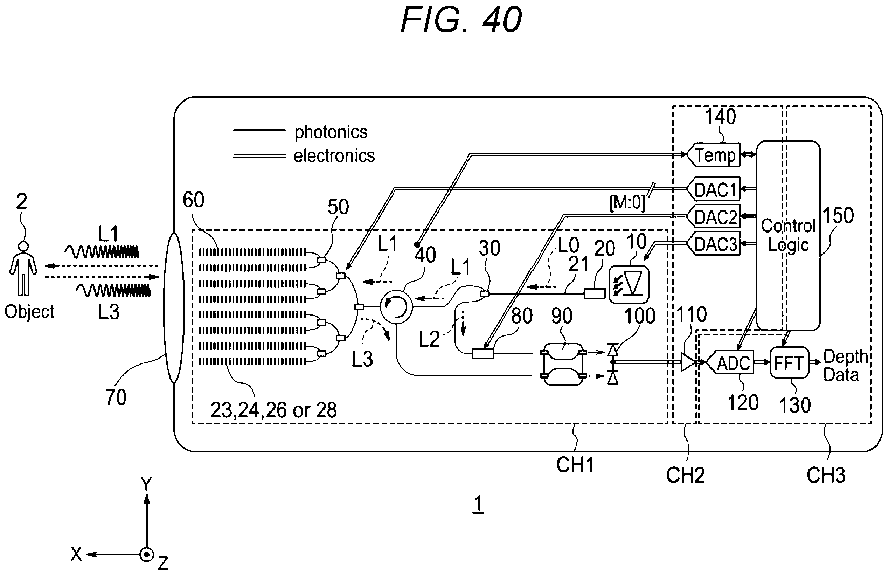

Fig. 40 is a block diagram illustrating a configuration example of a ranging device according to a twelfth embodiment. The ranging device 1 according to the twelfth embodiment is similar to that of the eleventh embodiment in terms of including the first semiconductor substrate CH1 and the second semiconductor substrate CH2 that are laminated. However, in the twelfth embodiment, the second semiconductor substrate CH2 includes the DACs 1 to 3, the TIA 110, the thermometer 140, and a part the logic control circuit 150, and the ADC 120, the FFT 130, and the other part of the logic control circuit 150 are provided on a third semiconductor substrate CH3.

For example, in a case where the ADC 120, the FFT 130, and the logic control circuit 150 include a field programmable gate array (FPGA), a discrete integrated circuit (IC), an application specific IC (ASIC), a system on chip (SoC), an accelerated processing unit (APU), and the like, these may be formed as the third semiconductor substrate CH3 on a substrate different from the second semiconductor substrate CH2.

In an electronics circuit, an analog circuit that handles analog signals of the DACs 1 to 3, the TIA 110, the thermometer 140, and a part of the logic control circuit 150 is formed on the second semiconductor substrate CH2, and the other logic circuit is formed on the third semiconductor substrate CH3. A simple and low-cost manufacturing process may be used for the analog circuit. Note that there may be a case where a part of the logic control circuit 150 includes an analog circuit or a memory circuit. On the other hand, it is preferable to apply a highly advanced process to the logic circuit. Therefore, the second semiconductor substrate CH2 can be formed at low cost, and the first and third semiconductor substrates CH1 and CH3 can achieve lower electric power consumption and a higher operation speed through miniaturization.

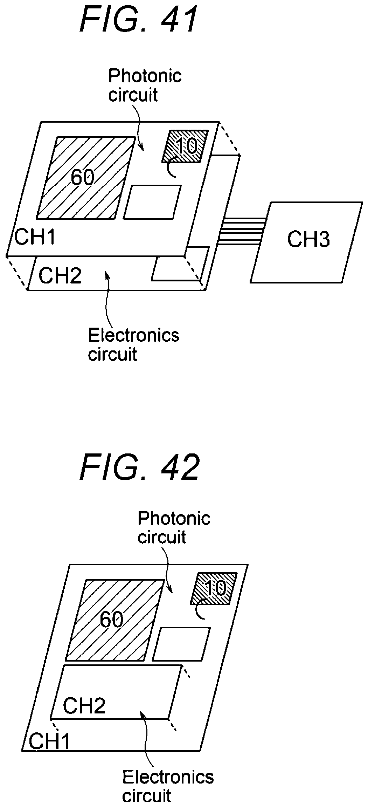

Fig. 41 is a conceptual diagram illustrating a laminated state of the first and second semiconductor substrates CH1 and CH2 of the twelfth embodiment. The third semiconductor substrate CH3 may be arranged separately from the second semiconductor substrate CH2 and electrically connected by a metal wire. Alternatively, the third semiconductor substrate CH3 may be laminated below the second semiconductor substrate CH2. In this case, a TSV or Cu-Cu bonding may be used for connecting the second and third semiconductor substrates CH2 and CH3.

Other configurations of the twelfth embodiment may be similar to those of the eleventh embodiment. Therefore, the twelfth embodiment can obtain effects similar to those of the eleventh embodiment. Note that the twelfth embodiment may be applied to any of the embodiments described above.

A cross-sectional structure of the twelfth embodiment may be either the laminated structure 1 or the laminated structure 2 illustrated in Fig. 59 or Fig. 60.

(Thirteenth Embodiment)

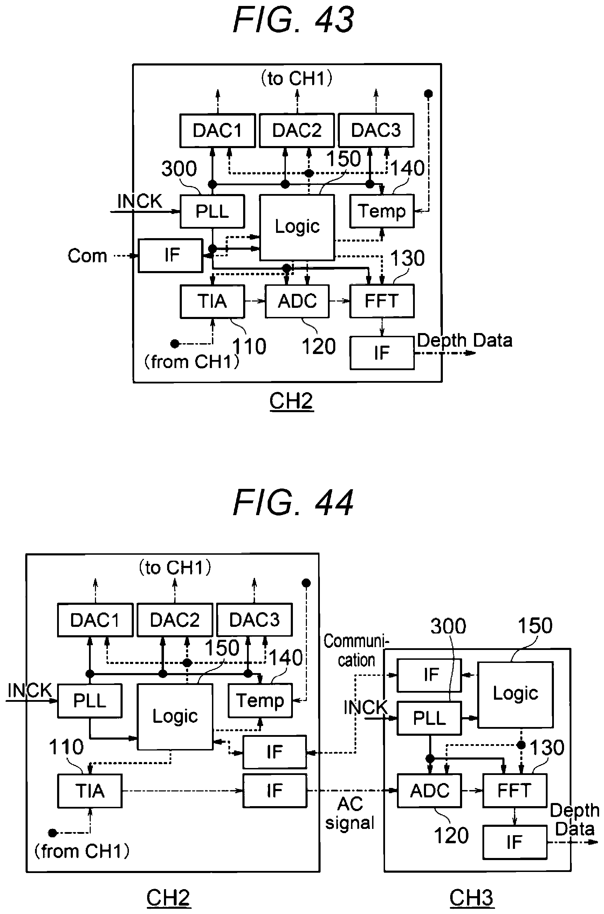

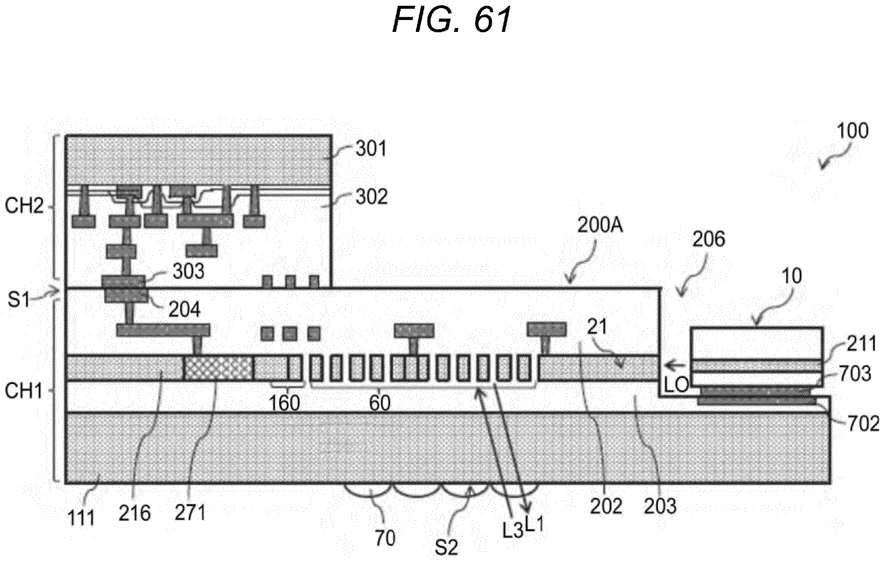

Fig. 42 is a block diagram illustrating a configuration example of a ranging device according to a thirteenth embodiment. In the thirteenth embodiment, the first semiconductor substrate CH1 is larger than the second semiconductor substrate CH2, and the second semiconductor substrate CH2 is laminated in a region other than the grating array 60 of the first semiconductor substrate CH1. In this case, an area of the region other than the grating array 60 of the first semiconductor substrate CH1 needs to be larger than an area of the second semiconductor substrate CH2. Note that the block diagram of the thirteenth embodiment may be the same as that of the eleventh embodiment.
According to the thirteenth embodiment, in a case where the first semiconductor substrate CH1 of a photonic circuit is relatively larger than the second semiconductor substrate CH2 of an electronics circuit, the second semiconductor substrate CH2 can be substrate-bonded onto the first semiconductor substrate CH1. Therefore, manufacturing cost can be reduced.
A cross-sectional structure of the thirteenth embodiment may be a laminated structure 3 illustrated in Fig. 61.
In a case where the ranging device 1 includes a plurality of laminated semiconductor substrates, an appropriate configuration as to which function is mounted on which semiconductor substrate differs depending on an area ratio between the photonic circuit and the electronics circuit. For example, Fig. 43 is a block diagram illustrating a configuration example of the second semiconductor substrate CH2 of the eleventh embodiment. In the example illustrated in Fig. 43, the DACs 1 to 3, the TIA 110, the ADC 120, the FFT 130, the thermometer 140, and the logic control circuit 150 are provided on the second semiconductor substrate CH2. In a case where the feedback circuit (PLL circuit) 300 is present, the feedback circuit 300 is also provided on the second semiconductor substrate CH2. The other photonic circuit is provided on the first semiconductor substrate CH1. The second semiconductor substrate CH2 of the thirteenth embodiment may also have the configuration of Fig. 43. Note that "INCK" is an internal clock signal, and "Com" is a command signal. "Depth Data" is distance data to a target whose distance has been measured. The distance data may be accompanied by speed data.
Fig. 44 is a block diagram illustrating a configuration example of the second and third semiconductor substrates CH2 and CH3 of the twelfth embodiment. In the example illustrated in Fig. 44, the ADC 120, the FFT 130, and a part of the logic control circuit 150 in the electronics circuit of Fig. 43 are provided on the third semiconductor substrate CH3. In a case where the feedback circuit 300 is present, the feedback circuit 300 is also provided on the third semiconductor substrate CH3. The other electronics circuit (the DACs 1 to 3, the TIA 110, the thermometer 140, and the other part of the logic control circuit 150) is provided on the second semiconductor substrate CH2. Furthermore, the other photonic circuit is provided on the first semiconductor substrate CH1. With such a configuration, the effects of the twelfth embodiment can be obtained.

(Configuration of Optical Amplifier 200)

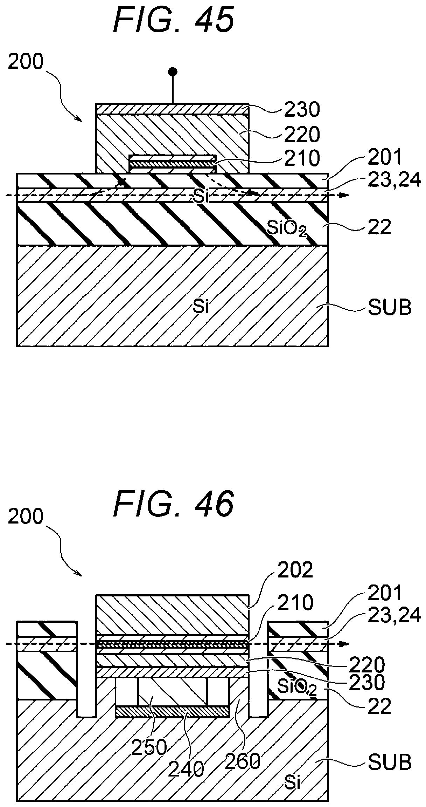

Fig. 45 is a cross-sectional view illustrating a configuration example of the optical amplifier (SOA) 200. The optical amplifier 200 includes a quantum well structure 210, a conductive portion 220, and an electrode 230. The quantum well structure 210 includes, for example, a P-type semiconductor, an N-type semiconductor, and an active layer (for example, InGaAsP or the like) sandwiched therebetween. For example, (GaAs, InP, or the like) is used for the substrate portion 220. For the electrode 230, for example, a metal material such as copper or tungsten is used.
An insulating film 201 is provided on the waveguides (SOI layers) 23 and 24. The quantum well structure 210 is provided on the insulating film 201. The quantum well structure 210 is covered with the conductive portion 220, and the electrode 230 is provided on the conductive portion 220. The electrode 230 is electrically connected to a semiconductor layer SUB via, for example, a metal wire or the like, and applies a voltage to the quantum well structure 210 via the conductive portion 220. Therefore, the quantum well structure 210 can amplify light leaking from the waveguides 23 and 24. A part of the light amplified in the quantum well structure 210 returns to the waveguides 23 and 24, and as a result, the light in the waveguides 23 and 24 is amplified.
The quantum well structure 210 is provided on the insulating film 201, and the insulating film 201 is provided on the waveguides 23 and 24. The degree of insertion of light from the waveguides 23 and 24 to the quantum well structure 210 and the degree of return of light from the quantum well structure 210 to the waveguides 23 and 24 depend on a film thickness of the insulating film 201. If the film thickness of the insulating film 201 is thin, a large amount of light is inserted from the waveguides 23 and 24 into the quantum well structure 210, and a large amount of light is returned from the quantum well structure 210 to the waveguides 23 and 24. Conversely, if the film thickness of the insulating film 201 is thick, a small amount of light is inserted from the waveguides 23 and 24 into the quantum well structure 210, and a small amount of light is returned from the quantum well structure 210 to the waveguides 23 and 24. In this manner, the degree of light coupling between the waveguides 23 and 24 and the quantum well structure 210 can be adjusted by the film thickness of the insulating film 201. Furthermore, the configuration of the optical amplifier 200 of Fig. 45 is relatively simple and can be manufactured at low cost.

Fig. 46 is a cross-sectional view illustrating another configuration example of the optical amplifier 200. The optical amplifier 200 includes the quantum well structure 210, the conductive portion 220, the electrode 230, an electrode 240, a bump 250, and pillars 260.

An SOI layer 27 (23, 24), the BOX layer 22, and a part of the semiconductor layer SUB are dug with the pillars 260 left, and the optical amplifier 200 is provided in a dent (cavity). Therefore, the BOX layer 22 and the waveguides 23 and 24 are separated by the optical amplifier 200. However, a height of the quantum well structure 210 of the optical amplifier 200 is set to be substantially equal to heights of the waveguides 23 and 24. Therefore, edges of the waveguides 23 and 24 are coupled with an edge of the quantum well structure 210, most of light from the waveguides 23 and 24 is inserted into the quantum well structure 210, and most of light amplified in the quantum well structure 210 is returned to the waveguides 23 and 24. Thus, the optical amplifier 200 of Fig. 46 can amplify light with higher efficiency than the optical amplifier 200 of Fig. 45.

The pillars 260 are formed by processing the BOX layer 22 and/or the semiconductor layer SUB. Therefore, for example, silicon or a silicon oxide film is used for the pillars 260. The electrode 240 is provided on the semiconductor layer SUB at a bottom portion between the pillars 260. For the electrode 240, for example, a metal material such as copper or tungsten is used. The bump 250 is provided on the electrode 240. For the bump 250, for example, a metal material such as solder is used. The electrode 230 is provided on the bump 250 and the pillars 260. The conductive portion 220 and the quantum well structure 210 are sequentially laminated on the electrode 230. The height of the quantum well structure 210 is set to be substantially equal to the heights of the waveguides 23 and 24. An insulating film 202 is provided on the quantum well structure 210. It is sufficient to adjust the height of the quantum well structure 210 by a height of the pillar 260.

There may be a gap between the quantum well structure 210 and the waveguides 23 and 24. Although not illustrated, this gap may be filled with a transparent film (for example, a silicon oxide film). Furthermore, the quantum well structure 210 may be in direct contact with the waveguides 23 and 24. Therefore, when light of the waveguides 23 and 24 is inserted into the quantum well structure 210 and light from the quantum well structure 210 is returned to the waveguides 23 and 24, a loss of the light can be suppressed.

The electrode 230 is provided under the quantum well structure 210, is electrically connected to the semiconductor layer SUB via the bump 250 and the electrode 240, and can apply a voltage to the quantum well structure 210.

(Configuration of Laser Light Source 10)

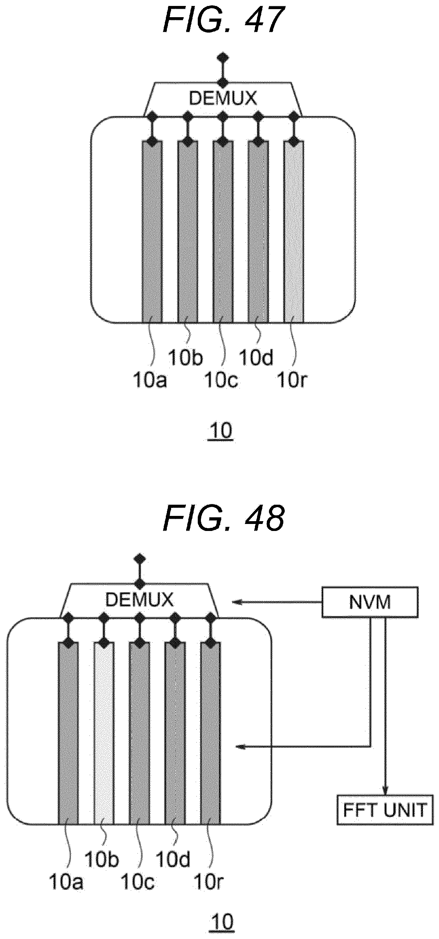

Figs. 47 and 48 are diagrams illustrating a configuration example of the laser light source 10. The laser light source 10 includes two or more laser generators 10a to 10d having different wavelengths. The laser generators 10a to 10d are solid-state laser devices. The laser generators 10a to 10d receive different currents and output beams of laser light having different wavelengths at a time. Therefore, the laser light L0 has multiplexed light of a plurality of wavelengths. In this case, the emission angle $\theta$ of the first light L1 is divided into a plurality of directions from Formula 4. That is, since the multiplexed laser light L0 having a plurality of wavelengths is used, the grating array 60 can emit the first light L1 at various angles $\theta$ in the X direction. Therefore, a scan operation in the X direction can be omitted to some extent.

Furthermore, the laser light source 10 further includes a redundant laser generator 10r. The redundant laser generator 10r is also a solid-state laser device. When any of the laser generators 10a to 10d is defective or fails, the redundant laser generator 10r generates laser light instead. For example, as illustrated in Fig. 48, in a case where the laser generator 10b has an initial defect or fails after shipment, the redundant laser generator 10r generates laser light instead of the laser generator 10b. When the same current as that of the laser generator 10b is supplied to the redundant laser generator 10r, the redundant laser generator 10r can generate laser light having the same wavelength as that of the laser generator 10b. Therefore, it is possible to suppress a decrease in a yield or extend the life of the ranging device 1.

In a case where a defect or failure of the laser generator 10b is found in an initial test or a periodic test, an identifier of the laser generator 10b is stored in a non-volatile memory NVM. The logic control circuit 150 may control the DAC 3 such that an output of the redundant laser generator 10r matches an output of the laser generator 10b on the basis of information of the non-volatile memory NVM.

Note that the laser generators 10a to 10d may generate beams of laser light having the same wavelength. That is, the laser light source 10 may be a multi-emitter. Even in this case, the redundant laser generator 10r can generate laser light instead of a laser generator (any of 10a to 10d) that has an initial defect or has failed after shipment.

Such a configuration can also be applied to the optical amplifier 200 or the BPDs 100 and 330 other than the laser light source 10. That is, a redundant portion may be provided in the optical amplifier 200 or the BPDs 100 and 330.

(Sensing of Peeling of Prism 70)

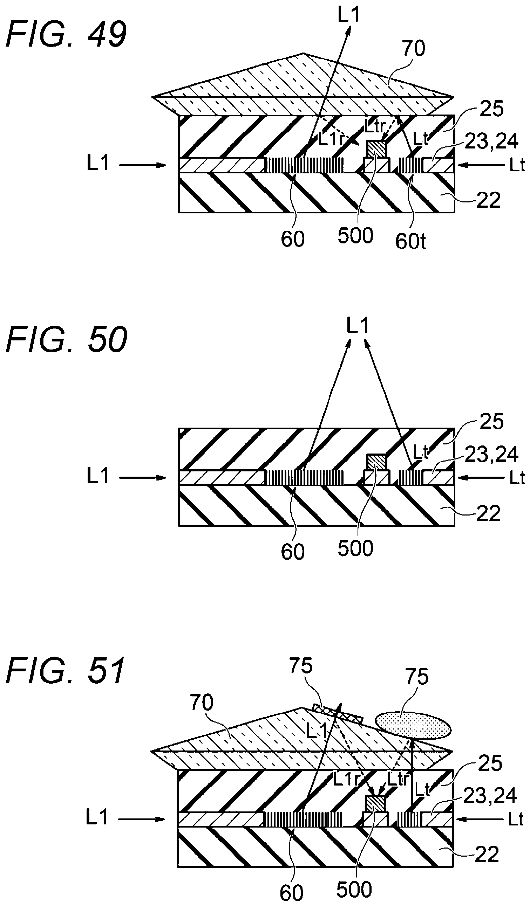

Figs. 49 and 50 are conceptual diagrams illustrating a function of sensing peeling of the prism 70. The ranging device 1 further includes a photodiode 500 provided on the waveguides 23 and 24 in the vicinity of the grating array 60. As illustrated in Fig. 49, the photodiode 500 detects a part L1r of the first light L1 reflected on a bottom surface of the prism 70. Note that a space or another film may be interposed between the prism 70 and the transparent insulating film 25.

On the other hand, the first light L1 is hardly reflected when the prism 70 is peeled off from the insulating film 25 or the like and disappears as illustrated in Fig. 50. Therefore, the reflected light L1r detected by the photodiode 500 becomes extremely small.

In this manner, a light intensity of the reflected light L1r detected by the photodiode 500 can be used as a parameter for sensing peeling of the prism 70. For example, in a case where the light intensity of the reflected light L1r detected by the photodiode 500 exceeds a predetermined first threshold, the logic control circuit 150 determines that the prism 70 is on the insulating film 25. In a case where the light intensity of the reflected light L1r detected by the photodiode 500 is equal to or lower than the predetermined first threshold, the logic control circuit 150 determines that the prism 70 is peeled off from the insulating film 25 or the like.

In a case where the first light L1 is scanned by adjusting the emission angle $\theta$ of the first light L1 depending on a wavelength of the first light L1 or a temperature of the grating array 60, the intensity of the reflected light L1r varies depending on the emission angle $\theta$ of the first light L1. Therefore, there is a case where the reflected light L1r is not suitable as the parameter for sensing a peeling abnormality of the prism 70.

Therefore, the ranging device 1 may further include a test grating array 60t that generates test light Lt dedicated to abnormality sensing separately from the grating array 60. The test grating array 60t receives the test light Lt having a predetermined intensity from the waveguides 23 and 24, and emits the test light Lt in a predetermined direction. In a case where the prism 70 is present on the insulating film 25, the test light Lt is reflected from the bottom surface of the prism 70 and sensed by the photodiode 500 as reflected light Ltr.

On the other hand, the reflected light Ltr detected by the photodiode 500 becomes extremely small when the prism 70 is peeled off from the insulating film 25 and disappears. The test light Lt is emitted at a constant output in a constant direction. Therefore, the photodiode 500 can accurately sense the peeling of the prism 70 even if the emission angle $\theta$ of the first light L1 is changed. In this manner, the sensing of peeling of the prism 70 may be performed using the test grating array 60t and the test light Lt.

In a case where the peeling of the prism 70 is sensed, the logic control circuit 150 outputs an abnormality signal to the outside and notifies a user of an abnormality of the ranging device 1. Furthermore, in this case, the logic control circuit 150 stops a distance measurement operation. Therefore, it is possible to suppress a malfunction at low cost, which leads to improvement of safety and reliability of the ranging device 1.

Note that an irradiation position of the test light Lt is defined, and thus, a reflective film such as a metal film may be provided only at the irradiation position of the test light Lt in the prism 70.

(Object Adhesion Sensing)

Fig. 51 is a conceptual diagram illustrating a function of sensing that an object adheres to the prism 70. A configuration of the ranging device 1 may be the same as the configuration illustrated in Fig. 49. As illustrated in Fig. 51, in a case where an object (or a human body or the like) 75 is in contact with or adheres to a surface of the prism 70, the photodiode 500 detects the reflected light L1r of the first light L1 or the reflected light Ltr of the test light Lt that is reflected on the surface of the prism 70.

On the other hand, in a case where the object 75 is not in contact with or does not adhere to the surface of the prism 70, the first light L1 or the test light Lt is hardly reflected on the surface of the prism 70. Therefore, the reflected light L1r or Ltr detected by the photodiode 500 decreases.

In this manner, a light intensity of the reflected light L1r or Ltr detected by the photodiode 500 can be used as a parameter for sensing peeling of the prism 70. For example, in a case where the light intensity of the reflected light L1r or Ltr detected by the photodiode 500 is equal to or lower than a predetermined second threshold, the logic control circuit 150 determines that the object 75 does not adhere to the surface of the prism 70. In a case where the light intensity of the reflected light L1r or Ltr detected by the photodiode 500 exceeds the predetermined second threshold, the logic control circuit 150 determines that the object 75 adheres to the surface of the prism 70.

In a case where the adhesion of the object 75 is sensed, the logic control circuit 150 outputs an abnormality signal to the outside and notifies a user of an abnormality of the ranging device 1. Furthermore, in this case, the logic control circuit 150 stops a distance measurement operation.

Therefore, a malfunction is suppressed at low cost, which leads to improvement of safety and reliability of the ranging device 1.

Note that the second threshold is preferably higher than the first threshold in order to have both the functions of sensing of peeling of the prism 70 and object adhesion sensing. Furthermore, a range between the first threshold and the second threshold can be referred to as an appropriate light intensity range of the reflected light L1r or Ltr.

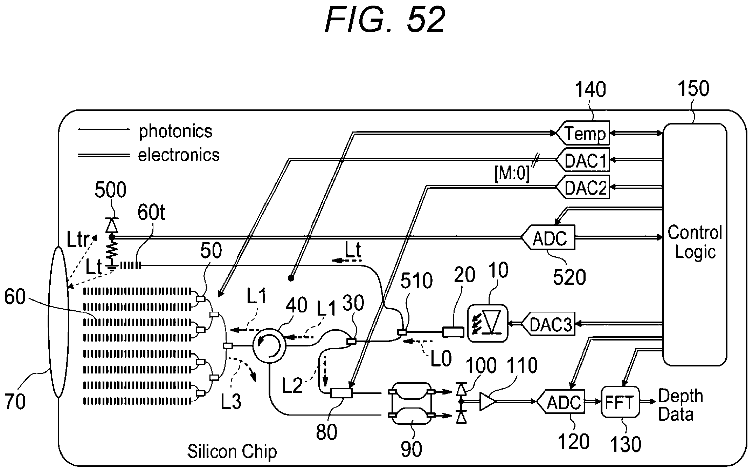

Fig. 52 is a block diagram illustrating a configuration of the ranging device 1 having the function of sensing of peeling of the prism 70 or object adhesion sensing. The ranging device 1 further includes a splitter 510, the test grating array 60t, the photodiode 500, and an ADC 520. Configurations and functions of the test grating array 60t and the photodiode 500 are as described above. The splitter 510 splits the laser light L0 and transmits a part thereof as the test light Lt to the test grating array 60t via a waveguide. Therefore, the test grating array 60t can emit the test light Lt to the prism 70. The reflected light Ltr from the prism 70 is detected by the photodiode 500. The photodiode 500 photoelectrically converts the reflected light Ltr into an electric signal. The electric signal from the photodiode 500 is subjected to AD conversion by the ADC 520 to be transmitted to the logic control circuit 150 as a digital value. The logic control circuit 150 compares the digital value with the first threshold and/or the second threshold to perform the sensing of peeling of the prism 70 or the object adhesion sensing.

Note that the splitter 510 and the test grating array 60t can be omitted in a case where the first light L1 from the grating array 60 is used for the peeling sensing or the object adhesion sensing.

(Sensing of Abnormality of Power of Laser Light)

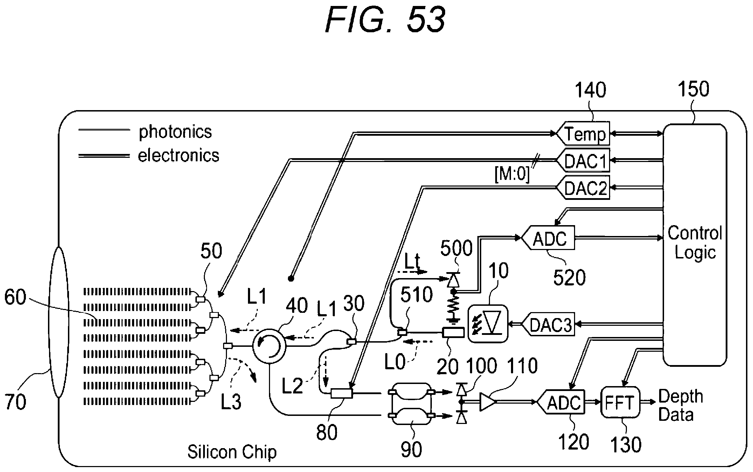

Fig. 53 is a block diagram illustrating a configuration example of the ranging device 1 having a function of sensing an abnormality of power of laser light. The ranging device 1 further includes the splitter 510, the photodiode 500, and the ADC 520. A configuration and a function of the photodiode 500 are as described above. However, the photodiode 500 directly detects a part of the test light Lt of the laser light L0 split by the splitter 510. That is, a waveguide that transmits the test light Lt from the splitter 510 is connected to the photodiode 500, and the test light Lt is directly inserted into the photodiode 500. Therefore, the photodiode 500 detects an intensity of the test light Lt. Since the intensity of the test light Lt is substantially proportional to an intensity of the laser light L0, the intensity of the laser light L0 is determined by detecting the intensity of the test light Lt.

The photodiode 500 photoelectrically converts the test light Lt into an electric signal. The electric signal from the photodiode 500 is subjected to AD conversion by the ADC 520 to be transmitted to the logic control circuit 150 as a digital value. The logic control circuit 150 compares the digital value with a third threshold to determine the intensity of the laser light L0. In a case where the digital value exceeds the third threshold, the logic control circuit 150 determines that the intensity of the laser light L0 is too high.

Furthermore, the logic control circuit 150 compares the digital value with a fourth threshold (< third threshold) to determine the intensity of the laser light L0. In a case where the digital value is equal to or less than the fourth threshold, the logic control circuit 150 determines that the intensity of the laser light L0 is too weak.

Therefore, an abnormality of power of the laser light source 10 can be sensed. Furthermore, the life of the laser light source 10 can be sensed.

In a case where an abnormality of the laser light source 10 is detected, the logic control circuit 150 outputs an abnormality signal to the outside to notify the user of the abnormality of the laser light source 10. Furthermore, in this case, the logic control circuit 150 stops a distance measurement operation. Therefore, a malfunction is suppressed at low cost, which leads to improvement of safety and reliability of the ranging device 1.

Note that a part of the laser light L0 is detected as the test light Lt in Fig. 53, but a part of the laser light L1 or L2 may be split as the test light Lt.

(Sensing of Abnormality of Frequency or Phase of Laser Light)

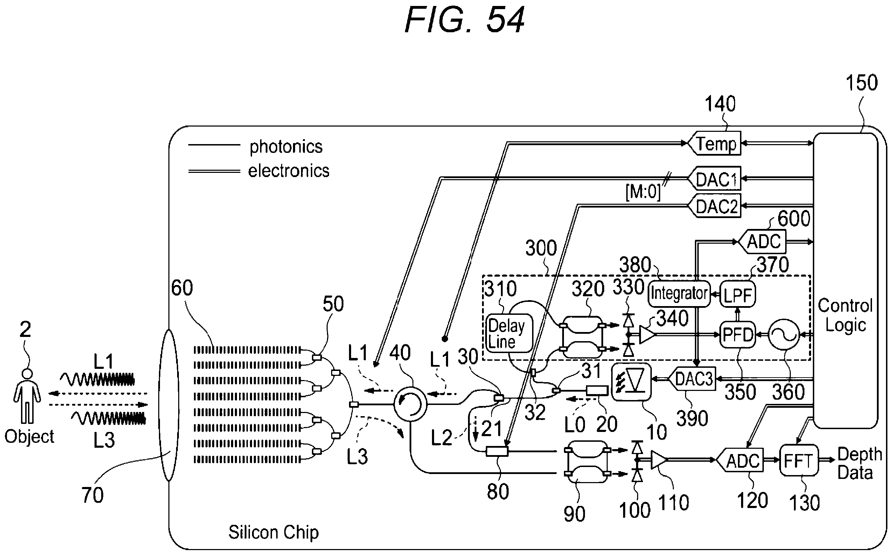

Fig. 54 is a block diagram illustrating a configuration example of the ranging device 1 having a function of sensing an abnormality of a frequency or a phase of laser light. The ranging device 1 further includes the PLL 300 in Fig. 35 and an ADC 600. The ADC 600 performs

AD conversion on a beat frequency from the integrator circuit 380 and transmits a digital value to the logic control circuit 150. The logic control circuit 150 compares the digital value with a fifth threshold, and determines that a change in a frequency or a phase of the laser light L0 is abnormal in a case where the beat frequency exceeds the fifth threshold.

Therefore, an abnormality of the frequency or the phase of the laser light L0 can be sensed. In a case where an abnormality of the laser light source 10 is detected, the logic control circuit 150 outputs an abnormality signal to the outside to notify the user of the abnormality of the laser light source 10. Furthermore, in this case, the logic control circuit 150 stops a distance measurement operation. For example, in a case where the frequency or the phase of the laser light L0 changes to an extent that cannot be corrected by feedback control, the logic control circuit 150 can stop the distance measurement operation. Therefore, a malfunction is suppressed at low cost, which leads to improvement of safety and reliability of the ranging device 1.

(Temperature Abnormality Sensing)

A function of sensing an abnormality of a chip temperature of the ranging device 1 will be described with reference to Fig. 1. The thermometer 140 measures a temperature of a photonic circuit and/or an electronics circuit and transmits a digital value thereof to the logic control circuit 150. This temperature information is compared with a sixth threshold in the logic control circuit 150. In a case where the temperature exceeds the sixth threshold, the logic control circuit 150 determines that the chip temperature of the ranging device 1 is abnormal.

Therefore, the abnormality of the chip temperature of the ranging device 1 can be sensed. In a case where the abnormality of the chip temperature of the ranging device 1 is sensed, the logic control circuit 150 outputs an abnormality signal to the outside and notifies the user of the abnormality of the ranging device 1. Furthermore, in this case, the logic control circuit 150 stops a distance measurement operation. Therefore, a malfunction is suppressed at low cost, which leads to improvement of safety and reliability of the ranging device 1.

Note that the thermometer 140 may monitor temperatures at a plurality of locations of the ranging device 1. The logic control circuit 150 may determine that the ranging device 1 is abnormal in a case where any of the temperatures at the plurality of locations is equal to or higher than the sixth threshold.

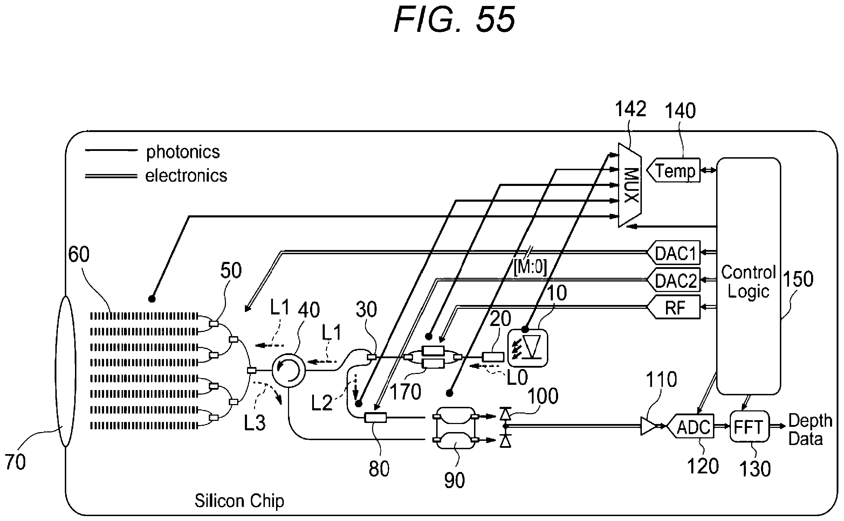

For example, Fig. 55 is a block diagram illustrating a configuration example of the ranging device 1 having a function of sensing temperatures at a plurality of locations. The ranging device 1 further includes a plurality of temperature detection terminals 141 and a multiplexer 142. The plurality of temperature detection terminals 141 is arranged at the plurality of locations of the ranging device 1. For example, the temperature detection terminals 141 are arranged near the grating array 60, the attenuator 80, the modulator 170, the laser light source 10, and the $2 \times 2$ coupler 90, respectively, and transmit the respective temperatures thereof. The multiplexer 142 is connected to the temperature detection terminals 141, and can selectively switch the temperature detection terminal 141 to be connected to the thermometer 140. The thermometer 140 detects a temperature of any of the plurality of temperature detection terminals 141 via the multiplexer 142 and sends the temperature information thereof to the logic control circuit 150.

Therefore, the ranging device 1 can sense temperature abnormalities at the plurality of locations. In a case where an abnormality of a temperature at any of the plurality of locations is sensed, the logic control circuit 150 outputs an abnormality signal to the outside and notifies the user of the abnormality of the ranging device 1. Furthermore, in this case, the logic control circuit 150 stops a distance measurement operation. Therefore, a malfunction is suppressed at low cost, which leads to improvement of safety and reliability of the ranging device 1.

Any plurality or all of the above-described types of abnormality sensing may be combined. The ranging device 1 can include any combination of the abnormality functions of the sensing of peeling of the prism 70, the object adhesion sensing, the power abnormality sensing, the sensing of an abnormality of a frequency or a phase of laser light, and the temperature abnormality sensing.

(Abnormality Detection Flow)

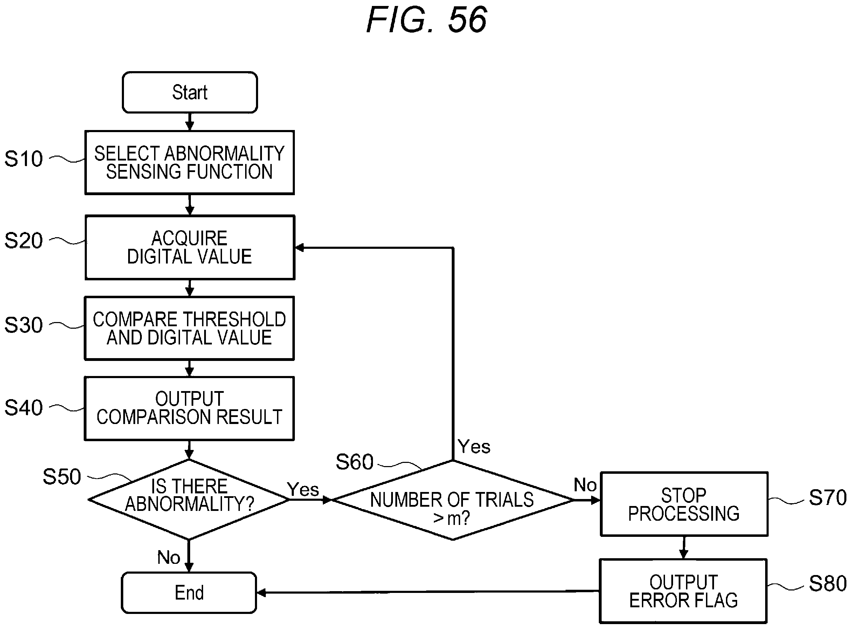

Fig. 56 is a flowchart illustrating a method for detecting various abnormalities described above.

First, the logic control circuit 150 selects an abnormality detection function to be used (S10). For example, the logic control circuit 150 selects the abnormality sensing function from the sensing of peeling of the prism 70, the object adhesion sensing, the power abnormality sensing, the sensing of an abnormality of a frequency or a phase of laser light, and the temperature abnormality sensing.

Next, the logic control circuit 150 obtains a digital value to be compared (S20). For example, the logic control circuit 150 obtains a digital value indicating the intensity of the reflected light Ltr, a digital value of the difference frequency, a digital value of the temperature, and the like.

Next, the logic control circuit 150 compares the digital value with a threshold corresponding to any of the first to sixth thresholds, and determines an abnormality (S30). A comparison result is output to the outside (S40).

As a result of the comparison between the digital value and the threshold, in a case where it is determined that "there is an abnormality" (YES in S50), the logic control circuit 150 retries (S60). In a case where it is determined that there is an abnormality even after the retry up to a predetermined number of times m (m is an integer of two or more), the logic control circuit 150 stops distance measurement processing (S70) and outputs an error flag to the outside (S80). In this case, the user repairs or replaces the ranging device 1.

As a result of the comparison between the digital value and the threshold, in a case where it is determined that "there is no abnormality" (NO in S50), the logic control circuit 150 continues the distance measurement processing by the ranging device 1. Furthermore, also in a case where "there is no abnormality" is determined as a result of the retry performed the predetermined number of times m, the logic control circuit 150 continues the distance measurement processing by the ranging device 1.

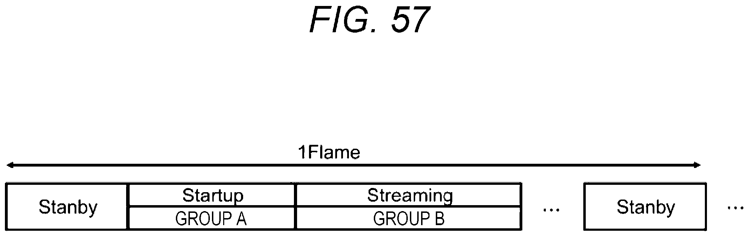

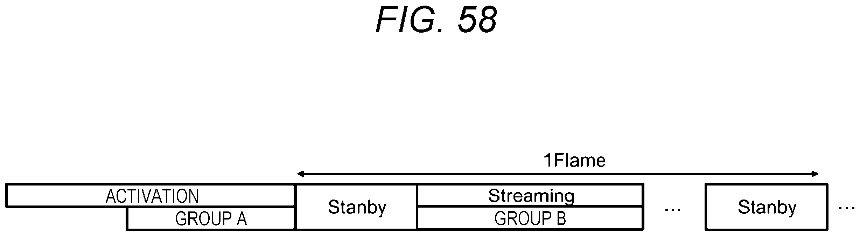

Figs. 57 and 58 are timing charts illustrating timings of failure sensing processing and abnormality sensing processing of the ranging device. A check group A refers to check items of a photonic circuit and an electronics circuit of the ranging device 1, and includes, for example, a power supply test, a short circuit test, an analog circuit failure test, and a logic circuit built-in self test (BIST). The check group A is checked for the failure sensing before the distance measurement processing is executed.

A check group B refers to abnormality items in the distance measurement processing of the ranging device 1, and includes the sensing of peeling of the prism 70, the object adhesion sensing, the power abnormality sensing, the sensing of an abnormality of a frequency or a phase of laser light, and the temperature abnormality sensing. The check group B is checked for the abnormality sensing during execution of the distance measurement processing.

For example, in Fig. 57, when startup is started from a standby state at the time of acquiring an image of one frame, a check of the check group A is executed. Therefore, it is possible to check the presence or absence of a failure of the ranging device 1 before streaming of one image. Next, the check group B is monitored during the streaming, and the presence or absence of an abnormality thereof is checked. An operation of checking the check groups A and B is repeatedly executed for every frame. Note that one frame is an operation of acquiring one image. The startup is processing of activating the ranging device 1 for the first time at the time of acquiring one frame. The streaming is an operation of scanning the first light L1 and acquiring the reflected light L3 at the time of acquiring an image of one frame.

For example, in Fig. 58, the check of the check group A is executed once at the time of activating the ranging device 1, thereafter, the check group A is not executed in a plurality of frames, and only the check group B is executed. After execution of the check group A when the ranging device 1 is activated, the check group B is monitored during streaming to check the presence or absence of an abnormality thereof at the time of acquiring an image of one frame. The operation of checking the check group B is repeatedly executed for every frame.

(Laminated Structure 1)

Fig. 59 is a cross-sectional view illustrating an example of a laminated structure of the ranging device 1. For example, as illustrated in Fig. 39, the first semiconductor substrate CH1 and the second semiconductor substrate CH2 are laminated on each other, and are electrically connected to each other by wire bonding on a bonding surface S1 between the first semiconductor substrate CH1 and the second semiconductor substrate CH2. Note that this laminated structure may be applied to the first and second semiconductor substrates CH1 and CH2 in any of Figs. 38 to 41.

(First Semiconductor Substrate CH1)

The first semiconductor substrate CH1 includes, for example, the laser light source 10, the coupler 20, the splitter 30, the circulator 40, the optical switch distribution network 50, the grating array 60, the prism 70, the attenuator 80, the $2 \times 2$ coupler 90, the BPD 100, and the photodiode 500 on a photonic integration circuit (PIC) layer 200A. The photodiode 500 is a PIN photodiode coupled to a waveguide, and may be GePD in which an island-shaped i-type Ge layer that is effectively p-type without formation of a depletion layer is thin, and a thick two-dimensionally grown i-type Ge layer becomes a depletion layer. Therefore, the sensitivity of the photodiode 500 can be improved.

The laser light source 10 is, for example, a chip-shaped edge emitting semiconductor laser, and emits the laser light L0 having a predetermined fixed wavelength (for example, 1550 nm) from an edge of an active layer 211. The laser light source 10 may be, for example, an edge emitting laser (EEL) or a distributed feedback laser (DFB)) which has a relatively high output. The laser light source 10 is mounted on the PIC layer 200A such that the laser light L0 is directly incident on an edge of the waveguide 21 of the PIC layer 200A. Therefore, the active layer 211 is provided at substantially the same height as the edge of the waveguide 21. A notched portion 206 is formed in the PIC layer 200A, and the laser light source 10 is mounted on a connection pad 207 embedded in a bottom surface of the notched portion 206. A bump 212 and the connection pad 207 of the laser light source 10 are made of, for example, Cu (copper), and are bonded to each other with the bump 212 made of Cu interposed therebetween. Since the height of the active layer 211 is controlled by a structure of a device such as the notched portion 206, alignment at the time of mounting the laser light source 10 becomes easy, and manufacturing cost can be reduced.

The PIC layer 200A includes a Si layer (SOI layer) 216, and an interlayer insulating film 202 and a BOX layer 203 which sandwich the Si layer 216. The BOX layer 203 and the Si layer 216 are obtained by removing a Si substrate (not illustrated) from the SOI substrate. The BOX layer 203 is made of a $SiO_2$ layer. The interlayer insulating film 202 is a layer formed on the SOI substrate 110, and has a configuration in which a plurality of patterned wiring layers and vias connecting the wiring layers are formed in a plurality of laminated $SiO_2$ layers. A surface of the interlayer insulating film 202 is a bottom surface of the first semiconductor substrate CH1 and is in contact with an upper surface of the second semiconductor substrate CH2 (an interlayer insulating film 25). A surface of the BOX layer 203 is an upper surface of the first semiconductor substrate CH1 and is an incident/emission surface S2.

The wiring layer 204 is exposed on the surface of the interlayer insulating film 202 of the first semiconductor substrate CH1. The wiring layer 204 is made of, for example, a metal material such as copper.

(Second Semiconductor Substrate CH2)

The second semiconductor substrate CH2 includes, for example, an electronics circuit (a CMOS circuit or the like) on the semiconductor layer 301. The electronics circuit includes the TIA 110, the ADC 120, the FFT 130, the thermometer 140, the DACs 1 to 4, the logic control circuit 150, the TIA 340, the PFD 350, the LPF 370, and the integrator circuit 380 in Fig. 35. A part thereof may be an analog circuit.

The electronics circuit formed on the semiconductor layer 301 is covered with an interlayer insulating film 302, and a wiring layer 303 is exposed on a surface of the interlayer insulating film 302 of the second semiconductor substrate CH2. The wiring layer 303 is made of, for example, a metal material such as copper.

The surfaces of the interlayer insulating film 202 and the wiring layer 204 are substantially flush, and surfaces of the interlayer insulating film 25 and the wiring layer 303 are also substantially flush. Therefore, when the interlayer insulating film 202 and the interlayer insulating film 25 are pasted to each other, the wiring layer 204 and the wiring layer 303 are directly wire bonded (Cu-Cu bonding). Therefore, the wiring layer 204 and the wiring layer 303 are electrically connected without routing a metal wire, a wiring, or the like. That is, the photonic circuit of the first semiconductor substrate CH1 and the electronics circuit of the second semiconductor substrate CH2 are connected to each other by direct wire bonding between the wiring layer 204 and the wiring layer 303.

With such a laminated structure, a layout area of the ranging device 1 can be reduced. Since the first and second semiconductor substrates CH1 and CH2 can be produced using manufacturing processes suitable for the photonic circuit and the electronics circuit, respectively, manufacturing cost is reduced.

(Laminated Structure 2)

Fig. 60 is a cross-sectional view illustrating another example of the layered structure of the ranging device 1. The first semiconductor substrate CH1 and the second semiconductor substrate CH2 are laminated on each other, and are electrically connected to each other via through electrodes 403 and 407 passing through the bonding surface S1 between the first semiconductor substrate CH1 and the second semiconductor substrate CH2. Note that this laminated structure may be applied to the first and second semiconductor substrates CH1 and CH2 in any of Figs. 38 to 41.

The second semiconductor substrate CH2 of the laminated structure 2 may have basically the same configuration as that of the laminated structure 1. However, a wiring 309 of the second semiconductor substrate CH2 is covered with the interlayer insulating film 302 and is not exposed from the surface thereof.

The first semiconductor substrate CH1 includes the interlayer insulating film 202 formed on the interlayer insulating film 302 of the second semiconductor substrate CH2, the waveguide 21, the grating array 60, the heater 160, the photodiode 500, and the like formed on the interlayer insulating film 202, the insulating film 203 covering these from above, wirings 409 and 404 connected to the waveguide 21 and the like, and the through electrodes 403.

In the laminated structure 2, the wiring 409 is formed in the insulating film 203. The wiring 404 is provided on the insulating film 203. The through electrode (through silicon via (TSV)) 403 extends in the laminating direction (substantially perpendicular to an interface S1) of the first and second semiconductor substrates CH1 and CH2, penetrates the bonding surface S1, and electrically connects the wiring 404 and the wiring 409.

Furthermore, a pad 408 is provided below the laser light source 10. The through electrode 407 is provided between the pad 408 and any portion of the wiring 309. The through electrode 403 extends in the laminating direction (direction substantially perpendicular to the interface S1) of the first and second semiconductor substrates CH1 and CH2, penetrates the bonding surface S1, and electrically connects the pad 408 and the wiring 309.

Other configurations of the laminated structure 2 may be the same as those of the laminated structure 1.

The through electrodes 403 and 407 are formed by forming a contact hole using a lithography technique and an etching technique after formation of the insulating film 203 and before formation of the wiring 404 or the pad 408, and embedding a metal material such as copper or tungsten, for example, in the contact hole.

In this manner, the first semiconductor substrate CH1 and the second semiconductor substrate CH2 laminated on each other may be electrically connected to each other via the through electrodes 403 and 407 which pass through the bonding surface S1.

With such a laminated structure, a layout area of the ranging device 1 can be reduced. Since the first and second semiconductor substrates CH1 and CH2 can be produced using manufacturing processes suitable for the photonic circuit and the electronics circuit, respectively, manufacturing cost is reduced.

(Laminated Structure 3)

Fig. 61 is a cross-sectional view illustrating still another example of the laminated structure of the ranging device 1. In Fig. 61, the first and second semiconductor substrates CH1 and CH2 are displayed upside down. Furthermore, a size of the second semiconductor substrate CH2 (an area viewed from a direction substantially perpendicular to the bonding surface S1) is smaller than that of the first semiconductor substrate CH1. The first semiconductor substrate CH1 and the second semiconductor substrate CH2 are laminated on each other, and are electrically connected to each other by wire bonding on the bonding surface S1 between the first semiconductor substrate CH1 and the second semiconductor substrate CH2. Note that this laminated structure may be applied to the first and second semiconductor substrates CH1 and CH2 in any of Fig. 42.

The notched portion 206 is provided on the bonding surface S1 side of the first semiconductor substrate CH1, and the laser light source 10 is provided in the notched portion 206 similarly to the laminated structure 1.

A silicon layer 111 is provided on a surface of the first semiconductor substrate CH1 opposite to the bonding surface S1, and the prism 70 is provided on a back surface (the incident/emission S2) of the silicon layer 111. The laser light L1 is emitted from the back surface S2 side, and the reflected light L3 is incident on the grating array 60 from the back surface S2 side. Note that in a case where the second semiconductor substrate CH2 covers a region other than the grating array 60 of the first semiconductor substrate CH1, the laser light L1 or the reflected light L3 may be emitted or incident from the bonding surface S1 side of the first semiconductor substrate CH1. Other configurations of the laminated structure 3 may be the same as those of the laminated structure 1.

With such a laminated structure, a layout area of the ranging device 1 can be reduced. Since the first and second semiconductor substrates CH1 and CH2 can be produced using manufacturing processes suitable for the photonic circuit and the electronics circuit, respectively, manufacturing cost is reduced.

[Modification Example A]

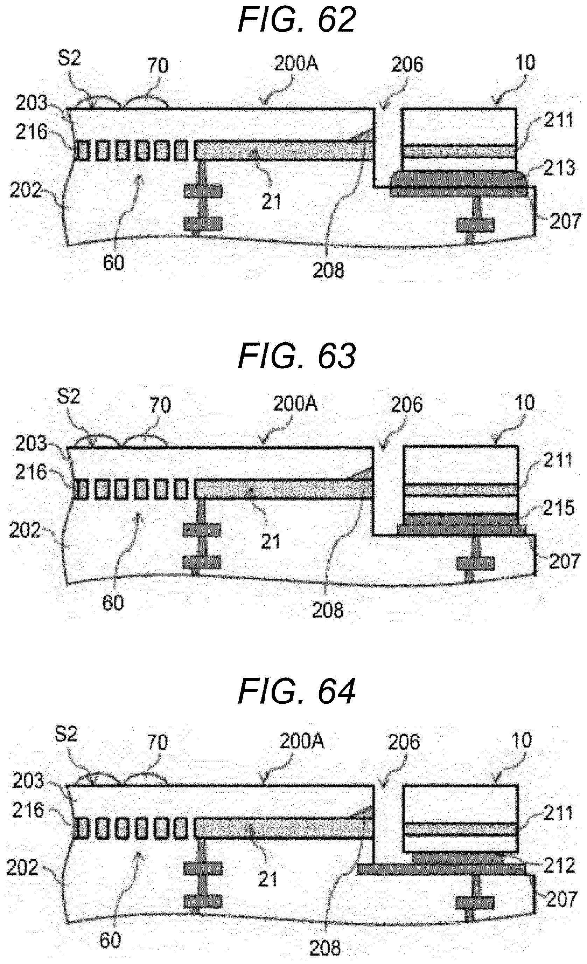

Figs. 62 to 64 are views illustrating a modification example of a method for mounting the laser light source 10. In each of the embodiments described above and modification examples thereof, the laser light source 10 may be mounted on the PIC layer 200A with an electrode (solder electrode) 213 interposed therebetween, for example, as illustrated in Fig. 62. For example, as illustrated in Fig. 63, the laser light source 10 may be mounted on the PIC layer 200A by bonding the solder electrode 213 of the laser light source 10 and the connection pad 207 made of Cu to each other. For example, as illustrated in Fig. 64, the laser light source 10 may be mounted on the connection pad 207 embedded in the PIC layer 200A via the bump 212.

[Modification Example B]

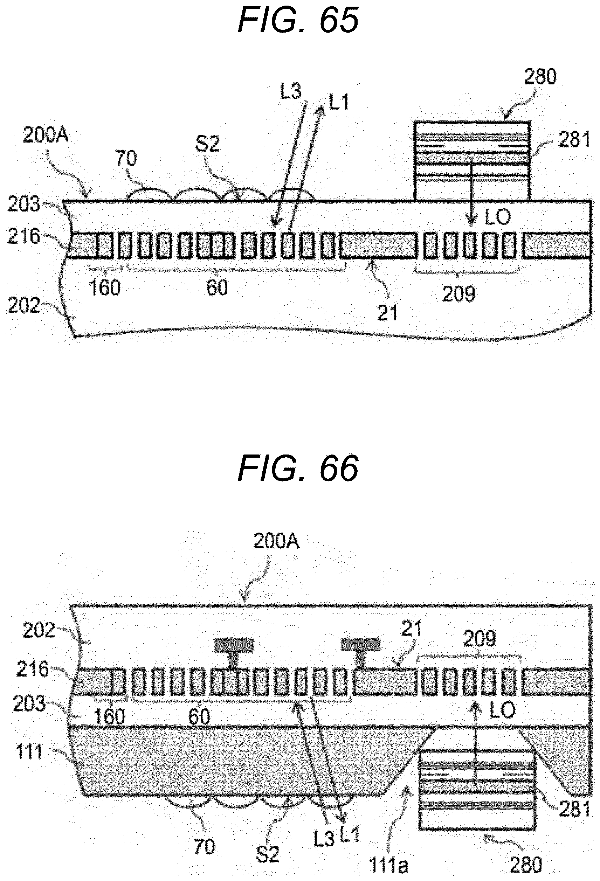

Figs. 65 to 68 are views illustrating another modification example of the method for mounting the laser light source 10. In each of the embodiments described above and the modification examples thereof, a laser light source 280 that emits the laser L0 in the laminating direction may be used instead of the laser light source 10 that emits the laser L0 from the edge. The laser light source 280 is a vertical cavity surface emitting laser (VCSEL) capable of stably outputting light with respect to the temperature. For example, as illustrated in Fig. 65, the laser light source 280 includes an active layer 281 and a pair of distributed Bragg reflector (DBR) layers sandwiching the active layer 281 in a thickness direction.

For example, as illustrated in Fig. 65, the PIC layer 200A may include an optical combiner 209 that guides the laser light L0 emitted from the laser light source 280 to the waveguide 21 at a location opposing the laser light source 280. At this time, the optical combiner 209 includes, for example, a diffraction grating formed in the Si layer 216. The optical combiner 209 may have, for example, a configuration similar to that of the grating array 60.

The PIC layer 200A may include the optical combiner 209, for example, as illustrated in Fig. 66. At this time, the Si layer 111 may have, for example, an opening portion 111a into which the laser light source 280 is fitted at a location opposing the laser light source 280. At this time, the laser light source 280 is fitted into the opening portion 111a. A resin or the like for fixing the laser light source 280 may be provided in the opening portion 111a.

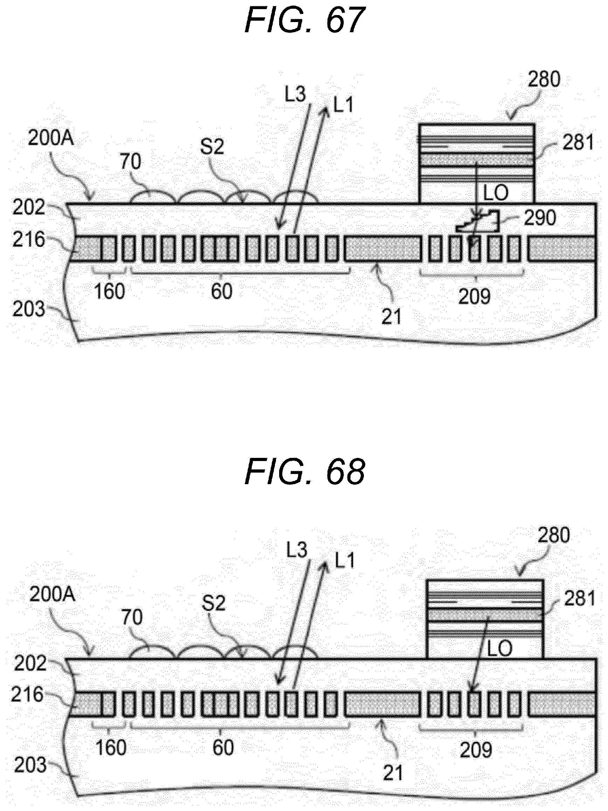

As illustrated in Fig. 67, an optical element (for example, a prism 290) that refracts the laser light L0 emitted from the laser light source 280 and causes the laser light L0 to be obliquely incident on the optical combiner 209 may be provided. The prism 290 is formed between the laser light source 280 and the optical combiner 209. The prism 290 may be formed in the interlayer insulating film 202, for example. Therefore, the laser light L0 can be efficiently propagated to the waveguide 21 and the grating array 60 in the optical combiner 209.

In this modification example, the laser light source 280 may emit the laser L0 in an inclined direction obliquely crossing the lamination direction. At this time, the laser L0 is obliquely incident on the optical combiner 209, for example, as illustrated in Fig. 68. Therefore, in the optical combiner 209, the laser light L0 can be efficiently inserted into the waveguide 21 and the grating array 60 and propagated.

<Application Example to Mobile Body>

Technology (present technology) according to the present disclosure is applicable to various products. For example, the technology according to the present disclosure may be implemented as a device mounted on any type of mobile body such as an automobile, an electric vehicle, a hybrid electric vehicle, a motorcycle, a bicycle, a personal mobility, an airplane, a drone, a ship, or a robot.

Fig. 58 is a block diagram illustrating a schematic configuration example of a vehicle control system which is an example of a mobile body control system to which the technology according to the present disclosure can be applied.

The vehicle control system 12000 includes a plurality of electronic control units connected to each other via a communication network 12001. In the example illustrated in Fig. 58, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 58, an audio speaker 12061, a display section 12062, and an instrument panel 12063 are illustrated as the output device. The display section 12062 may, for example, include at least one of an on-board display and a head-up display.

Fig. 59 is a diagram illustrating an example of an installation position of the imaging section 12031.

In Fig. 59, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that Fig. 59 illustrates an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 and the like, for example, among the components described above.

Note that the present technology can also employ the following configurations.

(1) A ranging device including a photonic circuit and an electric circuit on a same semiconductor chip,

the photonic circuit including: a light source; a waveguide that guides light from the light source; an optical switch distribution network that distributes first light split from the light; a grating array that outputs the first light distributed by the optical switch distribution network to an external target and receives the first light reflected from the target as reflected light; a first coupler that combines the reflected light with second light split from the light; and a first photodiode that photoelectrically converts light combined by the first coupler into a first electric signal, and the electric circuit including: a power supply that supplies electric power to the light source and the optical switch distribution network; and a controller that controls the power supply.

(2) The ranging device according to (1), in which the electric circuit further includes: a heater that heats the grating array; and a power supply control section that controls supply of electric power to the heater.

(3) The ranging device according to (2), in which the heater is provided to correspond to each of a plurality of waveguides provided in the grating array.

(4) The ranging device according to any one of (1) to (3), in which

the photonic circuit further includes a modulator that modulates the light from the light source, and
the electric circuit further includes a high frequency generating circuit that supplies a high-frequency signal to the modulator.

(5) The ranging device according to any one of (1) to (4), in which
the photonic circuit further includes:

a splitter that splits the light into the first light and the second light; and
a circulator that sends the first light to the optical switch distribution network and sends the second light to the first coupler.

(6) The ranging device according to any one of (1) to (4), in which
the photonic circuit further includes
a second coupler that splits the light into the first light and the second light, sends the first light to the optical switch distribution network, and sends the second light to the first coupler.

(7) The ranging device according to any one of (1) to (4), in which
the photonic circuit further includes:

a splitter that splits the light into the first light and the second light; and
a second coupler that splits the first light into third light and fourth light, sends the third light to the optical switch distribution network, and terminates the fourth light.

(8) The ranging device according to any one of (1) to (7), in which
the photonic circuit further includes
a light amplifier that is provided in the waveguide and amplifies the light or the first light.

(9) The ranging device according to any one of (1) to (8), further including a feedback circuit that detects a change in a phase of the light and performs feedback control of the light from the light source.

(10) The ranging device according to claim (9), in which
the feedback circuit includes:

a delay circuit that generates delay light obtained by delaying a part of the light from the light source;
a third coupler that combines another part of the light from the light source and the delay light;
a second photodiode that photoelectrically converts light combined by the third coupler into a second electric signal;
a comparison circuit that compares the second electric signal with a reference signal indicating a delay amount of the delay light and outputs a comparison result; and
an integrator circuit that integrates the comparison result and controls the power supply of the light source.

(11) The ranging device according to any one of (1) to (10), further including a signal processing circuit that executes distance measurement processing using the first electric signal and a second electric signal, in which the photonic circuit further includes:

a second splitter that splits the second light;
a third splitter that splits the reflected light;
the third coupler that combines a part of the second light split by the second splitter and a part of the reflected light split by the third splitter and subjected to phase modulation; and
a second photodiode that photoelectrically converts light combined by the third coupler into the second electric signal.

(12) The ranging device according to any one of (1) to (11), in which the grating array is separated into a transmission array that transmits the first light and a reception array that receives the reflected light.

(13) The ranging device according to any one of (1) to (12), in which

the photonic circuit is provided on a first semiconductor substrate,
the electronics circuit is provided on a second semiconductor substrate, and
the first and second semiconductor substrates are laminated on each other and electrically connected.

(14) The ranging device according to any one of (1) to (12), in which

the photonic circuit is provided on a first semiconductor substrate,
an analog circuit of the electronics circuit is provided on a second semiconductor substrate,
a digital circuit of the electronics circuit is provided on a third semiconductor substrate, and
at least the first and second semiconductor substrates are laminated on each other and electrically connected.

(15) The ranging device according to claim (13), in which

the first semiconductor substrate is larger than the second semiconductor substrate, and
the second semiconductor substrate is laminated on a region other than the grating array in the first semiconductor substrate.

(16) The ranging device according to any one of (1) to (15), in which the light source includes a plurality of first laser generators and a second laser generator that generates light in place of any first laser generator out of the plurality of first laser generators.

(17) The ranging device according to any one of (1) to (15), further including:

a prism provided above the grating array;
a photodiode that detects a part of the first light reflected from the prism; and
an AD converter that converts an electric signal from the photodiode into a digital value.

(18) The ranging device according to any one of (1) to (15), further including:

a prism provided above the grating array;
a test grating array that irradiates the prism with test light;
a photodiode that detects the test light reflected from the prism; and
an AD converter that converts an electric signal from the photodiode into a digital value.

(19) The ranging device according to any one of (1) to (18), further including:

a photodiode that detects a part of the light from the light source; and
an AD converter that converts an electric signal from the photodiode into a digital value.

(20) The ranging device according to (10), further including an AD converter that converts the comparison result into a digital value.

(21) The ranging device according to any one of (1) to (20), further including a thermometer that senses a temperature of any location of the photonic circuit or the electronics circuit and outputs the temperature as a digital value.

(22) The ranging device according to any one of (17) to (21), in which the controller compares the digital value with a threshold to determine an abnormality.

Note that the present disclosure is not limited to the above-described embodiments, and various modifications can be made without departing from the gist of the present disclosure. Furthermore, the effects described in the present description are merely examples and are not limited, and other effects may be provided.

REFERENCE SIGNS LIST

| | |
|---|---|
| 1 | Ranging device |
| 10 | Laser light source |
| 20 | Coupler |
| 30 | Splitter |
| 40 | Circulator |
| 50 | Optical switch distribution network |
| 60 | Grating array |
| 70 | Prism |
| 80 | Attenuator |
| 90 | 2×2 coupler |
| 100 | BPD |
| 110 | TIA |
| 120 | ADC |
| 130 | FFT calculation circuit |
| 140 | Thermometer |
| 150 | Logic control circuit |

**Claims**

1. A ranging device comprising a photonic circuit and an electric circuit on a same semiconductor chip,

   the photonic circuit including: a light source; a waveguide that guides light from the light source; an optical switch distribution network that distributes first light split from the light; a grating array that outputs the first light distributed by the optical switch distribution network to an external target and receives the first light reflected from the target as reflected light; a first coupler that combines the reflected light with second light split from the light; and a first photodiode that photoelectrically converts light combined by the first coupler into a first electric signal, and the electric circuit including: a power supply that supplies electric power to the light source and the optical switch distribution network; and a controller that controls the power supply.

2. The ranging device according to claim 1, wherein the electric circuit further includes: a heater that heats the grating array; and a power supply control section that controls supply of electric power to the heater.

3. The ranging device according to claim 2, wherein the heater is provided to correspond to each of a plurality of waveguides provided in the grating array.

4. The ranging device according to claim 1, wherein

   the photonic circuit further includes a modulator that modulates the light from the light source, and the electric circuit further includes a high frequency generating circuit that supplies a high-frequency signal to the modulator.

5. The ranging device according to claim 1, wherein
   the photonic circuit further includes:

   a splitter that splits the light into the first light and the second light; and
   a circulator that sends the first light to the optical switch distribution network and sends the second light to the first coupler.

6. The ranging device according to claim 1, wherein

the photonic circuit further includes
a second coupler that splits the light into the first light and the second light, sends the first light to the optical switch distribution network, and sends the second light to the first coupler.

7. The ranging device according to claim 1, wherein
the photonic circuit further includes:

a splitter that splits the light into the first light and the second light; and
a second coupler that splits the first light into third light and fourth light, sends the third light to the optical switch distribution network, and terminates the fourth light.

8. The ranging device according to claim 1, wherein

the photonic circuit further includes
a light amplifier that is provided in the waveguide and amplifies the light or the first light.

9. The ranging device according to claim 1, further comprising a feedback circuit that detects a change in a phase of the light and performs feedback control of the light from the light source.

10. The ranging device according to claim 9, wherein
the feedback circuit includes:

a delay circuit that generates delay light obtained by delaying a part of the light from the light source;
a third coupler that combines another part of the light from the light source and the delay light;
a second photodiode that photoelectrically converts light combined by the third coupler into a second electric signal;
a comparison circuit that compares the second electric signal with a reference signal indicating a delay amount of the delay light and outputs a comparison result; and
an integrator circuit that integrates the comparison result and controls the power supply of the light source.

11. The ranging device according to claim 1, further comprising a signal processing circuit that executes distance measurement processing using the first electric signal and a second electric signal,
wherein the photonic circuit further includes:

a second splitter that splits the second light;
a third splitter that splits the reflected light;
the third coupler that combines a part of the second light split by the second splitter and a part of the reflected light split by the third splitter and subjected to phase modulation; and
a second photodiode that photoelectrically converts light combined by the third coupler into the second electric signal.

12. The ranging device according to claim 1, wherein the grating array is separated into a transmission array that transmits the first light and a reception array that receives the reflected light.

13. The ranging device according to claim 1, wherein

the photonic circuit is provided on a first semiconductor substrate,
the electronics circuit is provided on a second semiconductor substrate, and
the first and second semiconductor substrates are laminated on each other and electrically connected.

14. The ranging device according to claim 1, wherein

the photonic circuit is provided on a first semiconductor substrate,
an analog circuit of the electronics circuit is provided on a second semiconductor substrate,
a digital circuit of the electronics circuit is provided on a third semiconductor substrate, and
at least the first and second semiconductor substrates are laminated on each other and electrically connected.

15. The ranging device according to claim 13, wherein

the first semiconductor substrate is larger than the second semiconductor substrate, and
the second semiconductor substrate is laminated on a region other than the grating array in the first semiconductor substrate.

**16.** The ranging device according to claim 1, wherein the light source includes a plurality of first laser generators and a second laser generator that generates light in place of any first laser generator out of the plurality of first laser generators.

**17.** The ranging device according to claim 1, further comprising:

a prism provided above the grating array;
a photodiode that detects a part of the first light reflected from the prism; and
an AD converter that converts an electric signal from the photodiode into a digital value.

**18.** The ranging device according to claim 1, further comprising:

a prism provided above the grating array;
a test grating array that irradiates the prism with test light;
a photodiode that detects the test light reflected from the prism; and
an AD converter that converts an electric signal from the photodiode into a digital value.

**19.** The ranging device according to claim 1, further comprising:

a photodiode that detects a part of the light from the light source; and
an AD converter that converts an electric signal from the photodiode into a digital value.

**20.** The ranging device according to claim 10, further comprising an AD converter that converts the comparison result into a digital value.

**21.** The ranging device according to claim 1, further comprising a thermometer that senses a temperature of any location of the photonic circuit or the electronics circuit and outputs the temperature as a digital value.

**22.** The ranging device according to claim 17, wherein the controller compares the digital value with a threshold to determine an abnormality.

FIG. 1

EP 4 418 001 A1

## FIG. 2

21

## FIG. 3

21

# FIG. 4

L0

Si

29

27

28

21

## FIG. 5A

## FIG. 5B

# FIG. 6A

# FIG. 6B

## FIG. 7A

## FIG. 7B

## FIG. 8

## FIG. 9

*FIG. 10*

*FIG. 11*

## FIG. 12

## FIG. 13

## FIG. 14

## FIG. 15

## FIG. 16A

Pn — Signal    GND — Pp

CNTn —

24n  24p

25 —                        CNTp

Dffn — n+ | n | p | p+ — Dffp

23n  23p   SiO₂ — 22

## FIG. 16B

24

24n  24p

Pn —
80

Pp

Dffn —

n+ | n | p | p+

Dffp

23n

23p — 25

23  L2

## FIG. 17A

## FIG. 17B

## FIG. 18A

Pn — Signal
CNTn

25

Dffn — n+ | n | p | p+ — Dffp

28n 28p SiO₂ — 22

GND — Pp
CNTp

## FIG. 18B

Pn
80
Dffn — n+

n p

28n 28p — 25

28

L2

Pp

Dffp

# FIG. 19

EP 4 418 001 A1

FIG. 20

EP 4 418 001 A1

## FIG. 21

## FIG. 22

## FIG. 23

## FIG. 24

## FIG. 25

## FIG. 26

## FIG. 27

## FIG. 28

## FIG. 29

EP 4 418 001 A1

## FIG. 30

$RF\_a = \Phi \cos \Omega t$

L0a  L0a1  $\pi$  L0a

$L0 = e^{i\omega t}$

L0a2

L0b1  $\pi$

L0b  L0b2  L0b  $\pi/2$  $L0 = e^{i\omega t}\{J_{-3}(\Phi)e^{-3i\Omega t} + J_{+1}(\Phi)e^{i\Omega t}\}$

$RF\_b = \Phi \sin \Omega t$

170

## FIG. 31

Pn  Signal  24  GND  Pp

CNTn  24n  24p  CNTp  25

Dffn  n+  n  p  p+  Dffp

23n  23p  SiO₂  22

23

170

FIG. 32

# FIG. 33

EP 4 418 001 A1

## FIG. 34

EP 4 418 001 A1

FIG. 35

EP 4 418 001 A1

## FIG. 36

FIG. 37

EP 4 418 001 A1

FIG. 38

# FIG. 39

Photonic circuit

60

CH1

CH2

10

Electronics circuit

## FIG. 40

EP 4 418 001 A1

# FIG. 41

Photonic
circuit

10

60

CH1

CH2

CH3

Electronics
circuit

# FIG. 42

Photonic
circuit

10

60

CH2

CH1

Electronics
circuit

# FIG. 43

CH2

# FIG. 44

CH2                                    CH3

## FIG. 45

200

230
220
210
201
23,24
Si
SiO2
22

SUB
Si

## FIG. 46

200

202
210
201
23,24
220
230
22
SiO2
Si

250
240
260
SUB
Si

## FIG. 47

10a  10b  10c  10d  10r

10

## FIG. 48

DEMUX    NVM

FFT UNIT

10a  10b  10c  10d  10r

10

*FIG. 49*

*FIG. 50*

*FIG. 51*

FIG. 52

FIG. 53

EP 4 418 001 A1

FIG. 54

EP 4 418 001 A1

# FIG. 55

*FIG. 56*

EP 4 418 001 A1

# FIG. 57

1Flame

| | | | | | |
|---|---|---|---|---|---|
| Stanby | Startup | Streaming | ... | Stanby | ... |
| | GROUP A | GROUP B | | | |

EP 4 418 001 A1

# FIG. 58

1Flame

| ACTIVATION | | Stanby | Streaming | | ... | Stanby | ... |
| GROUP A | | | GROUP B | | | | |

# FIG. 59

EP 4 418 001 A1

FIG. 60

*FIG. 61*

## FIG. 62

## FIG. 63

## FIG. 64

## FIG. 65

## FIG. 66

## FIG. 67

## FIG. 68

# FIG. 69

EP 4 418 001 A1

## FIG. 70

## INTERNATIONAL SEARCH REPORT

| International application No. |
| --- |
| **PCT/JP2022/032010** |

**A.    CLASSIFICATION OF SUBJECT MATTER**

**G01S 7/481**(2006.01)i; **G02B 6/12**(2006.01)i; **H01L 27/15**(2006.01)i
FI:    G01S7/481 Z; H01L27/15 C; G02B6/12 301

According to International Patent Classification (IPC) or to both national classification and IPC

**B.    FIELDS SEARCHED**

Minimum documentation searched (classification system followed by classification symbols)

G01S 7/48 - G01S 7/51; G01S 17/00 - G01S 17/95

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| Y | US 2019/0377135 A1 (MANSOURI RAD, Mohammad Mehdi) 12 December 2019 (2019-12-12) <br> paragraphs [0038]-[0082], [0104], fig. 1A-8 | 1-16, 19-21 |
| A | | 17-18, 22 |
| Y | US 2021/0124024 A1 (GM GLOBAL TECHNOLOGY OPERATIONS LLC) 29 April 2021 (2021-04-29) <br> paragraphs [0029]-[0041], fig. 1 | 1-16, 19-21 |
| Y | JP 2018-512600 A (STROBE, INC.) 17 May 2018 (2018-05-17) <br> paragraphs [0039]-[0043], fig. 1 | 1-16, 19-21 |
| Y | WO 2019/225445 A1 (KEIO UNIVERSITY) 28 November 2019 (2019-11-28) <br> paragraphs [0094], [0095], fig. 19B | 2-3 |
| Y | US 2021/0083449 A1 (ROBERT BOSCH GMBH) 18 March 2021 (2021-03-18) <br> paragraphs [0029]-[0037], fig. 6, 8a | 9-10, 20 |
| Y | JP 2021-012069 A (MITSUTOYO CORP.) 04 February 2021 (2021-02-04) <br> paragraphs [0002], [0025]-[0027], [0047]-[0050], fig. 5 | 11 |

☑ Further documents are listed in the continuation of Box C.       ☑ See patent family annex.

| | |
| --- | --- |
| *    Special categories of cited documents: <br> "A"   document defining the general state of the art which is not considered to be of particular relevance <br> "E"   earlier application or patent but published on or after the international filing date <br> "L"   document which may throw doubts on priority claim(s) or which is cited to establish the publication date of another citation or other special reason (as specified) <br> "O"   document referring to an oral disclosure, use, exhibition or other means <br> "P"   document published prior to the international filing date but later than the priority date claimed | "T"   later document published after the international filing date or priority date and not in conflict with the application but cited to understand the principle or theory underlying the invention <br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other such documents, such combination being obvious to a person skilled in the art <br> "&"   document member of the same patent family |

| Date of the actual completion of the international search | Date of mailing of the international search report |
| --- | --- |
| **20 September 2022** | **04 October 2022** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

## INTERNATIONAL SEARCH REPORT

International application No.

**PCT/JP2022/032010**

**C.    DOCUMENTS CONSIDERED TO BE RELEVANT**

| Category* | Citation of document, with indication, where appropriate, of the relevant passages | Relevant to claim No. |
|---|---|---|
| Y | US 2018/0052378 A1 (SAMSUNG ELECTRONICS CO., LTD.) 22 February 2018 (2018-02-22)<br>    paragraphs [0113], [0122]-[0124], fig. 13A | 13-15 |
| Y | JP 2014-202716 A (HITACHI HIGH-TECHNOLOGIES CORP.) 27 October 2014 (2014-10-27)<br>    paragraphs [0041], [0042] | 19 |
| Y | CN 207304106 U (BEIJING RUITIANHONG ELECTRIC CO., LTD.) 01 May 2018 (2018-05-01)<br>    paragraph [0018], fig. 1 | 21 |

Form PCT/ISA/210 (second sheet) (January 2015)

## INTERNATIONAL SEARCH REPORT
### Information on patent family members

| International application No. |
| --- |
| **PCT/JP2022/032010** |

| Patent document cited in search report | | | Publication date (day/month/year) | Patent family member(s) | | | Publication date (day/month/year) |
| --- | --- | --- | --- | --- | --- | --- | --- |
| US | 2019/0377135 | A1 | 12 December 2019 | WO | 2019/233323 | A1 | |
| | | | | CN | 112219162 | A | |
| US | 2021/0124024 | A1 | 29 April 2021 | US | 2021/0124025 | A1 | |
| | | | | US | 2021/0124031 | A1 | |
| | | | | US | 2021/0124048 | A1 | |
| | | | | US | 2021/0124118 | A1 | |
| JP | 2018-512600 | A | 17 May 2018 | WO | 2016/164435 | A1 | |
| | | | | paragraphs [0048]-[0052], fig. 1 | | | |
| | | | | JP | 6626957 | B2 | |
| | | | | US | 2016/0299228 | A1 | |
| | | | | US | 2019/00943661 | A1 | |
| | | | | CN | 107567592 | A | |
| WO | 2019/225445 | A1 | 28 November 2019 | (Family: none) | | | |
| US | 2021/0083449 | A1 | 18 March 2021 | WO | 2019/121069 | A1 | |
| | | | | CN | 111492263 | A | |
| JP | 2021-012069 | A | 04 February 2021 | US | 2021/0011155 | A1 | |
| | | | | paragraphs [0002], [0028]-[0030], [0050]-[0053], fig. 5 | | | |
| | | | | DE | 102020208207 | A1 | |
| | | | | CN | 112180389 | A | |
| US | 2018/0052378 | A1 | 22 February 2018 | KR | 10-2018-0020035 | A | |
| | | | | CN | 107765363 | A | |
| JP | 2014-202716 | A | 27 October 2014 | (Family: none) | | | |
| CN | 207304106 | U | 01 May 2018 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20210109195 A
- US 20210018598 A
- US 20170184450 A
- US 20180267250 A